(19) Europäisches Patentamt
European Patent Office
Office européen des brevets

(11) EP 3 508 349 B1

(12) **EUROPEAN PATENT SPECIFICATION**

(45) Date of publication and mention of the grant of the patent:
**15.12.2021 Bulletin 2021/50**

(21) Application number: **17846133.1**

(22) Date of filing: **15.08.2017**

(51) Int Cl.:
***B41C 1/10*** *(2006.01)* ***G03F 7/00*** *(2006.01)*
***G03F 7/004*** *(2006.01)* ***C09B 23/01*** *(2006.01)*

(86) International application number:
**PCT/JP2017/029410**

(87) International publication number:
**WO 2018/043125 (08.03.2018 Gazette 2018/10)**

(54) **LITHOGRAPHIC PRINTING PLATE PRECURSOR AND PLATE-MAKING METHOD USING SAME**

LITHOGRAPHISCHER DRUCKPLATTENVORLÄUFER UND PLATTENHERSTELLUNGSVERFAHREN UNTER VERWENDUNG DAVON

PRÉCURSEUR DE PLAQUE D'IMPRESSION LITHOGRAPHIQUE ET PROCÉDÉ DE FABRICATION DE PLAQUE L'UTILISANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.08.2016 JP 2016170352**

(43) Date of publication of application:
**10.07.2019 Bulletin 2019/28**

(73) Proprietor: **FUJIFILM Corporation**
**Tokyo 106-8620 (JP)**

(72) Inventors:
- **OCHIMIZU Tomoki**
**Haibara-gun**
**Shizuoka 421-0396 (JP)**
- **AIZU Kohei**
**Haibara-gun**
**Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**EP-A1- 2 072 570** **EP-A2- 1 428 676**
**WO-A1-2006/005688** **WO-A1-2014/132721**
**WO-A1-2016/027886** **JP-A- 2004 195 662**
**JP-A- 2008 544 322** **US-A1- 2005 026 083**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

**Description**

**BACKGROUND OF THE INVENTION**

1. Field of the Invention

The present invention relates to a lithographic printing plate precursor and a plate-making method using the same. The present invention particularly relates to a lithographic printing plate precursor capable of image recording and on-machine development using a variety of lasers on the basis of a digital signal and a plate-making method using the same.

2. Description of the Related Art

Generally, a lithographic printing plate includes a lipophilic image area that receives ink in a printing process and a hydrophilic non-image area that receives dampening water. Lithographic printing is a method in which the properties of water and oil-based ink that repel each other are used, the lipophilic image area of the lithographic printing plate is used as an ink-receiving portion, the hydrophilic non-image area is used as a dampening water-receiving portion (non-ink-receiving portion), a difference in the adhesive property of ink to the surface of the lithographic printing plate is caused, the ink is inked only in the image area, and then the ink is transferred to a body to be printed such as paper, thereby carrying out printing.

In the related art, a lithographic printing plate precursor (PS plate) having a lipophilic photosensitive resin layer (an image-recording layer or an image-forming layer) on a hydrophilic support was used, image exposure was carried out on this lithographic printing plate precursor through a mask such as a lith film, then, a development process was carried out using an alkali development liquid or the like, an image-recording layer corresponding to an image area was left, and an unnecessary image-recording layer corresponding to a non-image area was dissolved and removed, thereby obtaining a lithographic printing plate.

A plate-making step of producing a lithographic printing plate from a lithographic printing plate precursor has been simplified, and, regarding the image exposure, at the moment, the lithographic printing plate is obtained using a computer to plate (CTP) technique. That is, a lithographic printing plate precursor was directly scanned and exposed using a laser or a laser diode without using a lith film, and a development process was carried out, thereby obtaining a lithographic printing plate.

In recent years, a method called on-machine development in which, in the plate-making step of the lithographic printing plate precursor, an image-recording layer from which an unnecessary portion of a lithographic printing plate precursor is removed in an ordinary printing step is used, image exposure is carried out, and then the non-image area is removed on a printer, thereby obtaining a lithographic printing plate has been proposed. According to this method, in response to a digitalization technique that electronically processes, accumulates, and outputs image information using a computer, digitalized image information is supported by a highly convergent radiative ray such as laser light, image exposure is carried out by, for example, scanning and exposing a lithographic printing plate precursor, and then a non-image area is removed using at least one of printing ink and dampening water on a printer, whereby a lithographic printing plate can be obtained. Therefore, it is possible to omit a development process step of a lithographic printing plate which has been an essential step in the printing industry of the related art, thus, a plate-making operation can be carried out in a completely dry environment (no liquid is used), and it becomes possible to significantly decrease the load in terms of operation and environment.

A lithographic printing plate precursor preferably to on-machine development is a lithographic printing plate precursor having an image-recording layer from which a non-image area can be removed using at least one of printing ink and dampening water on a printer (hereinafter, also referred to as the on-machine development-type lithographic printing plate precursor).

As the on-machine development-type lithographic printing plate precursor, a lithographic printing plate precursor having a radical polymerization-type image-recording layer containing an infrared absorber, a polymerization initiator, and a polymerizable compound on a support (for example, WO2016/027886A) and a lithographic printing plate precursor having a thermal fusion-type image-recording layer containing an infrared absorber and a thermoplastic polymer particle on a support (for example, JP2008-544322A) are known.

Generally, as a previous step of attaching the lithographic printing plate to the printer, an operation of inspecting and identifying an image on the lithographic printing plate (the inspection of the plate) in order to check whether an image is recorded as intended on the lithographic printing plate is carried out. In ordinary lithographic printing plate precursors that are subjected to a development process step, generally, once an image-recording layer is colored, a colored image can be obtained by means of a development process, and thus it is easy to check the image before the printing plate is attached to a printer.

Meanwhile, in on-machine development-type lithographic printing plate precursors on which an ordinary development process is not carried out, it is difficult to check an image on the lithographic printing plate precursor in a phase of attaching the lithographic printing plate precursor to a printer, and thus it is impossible to sufficiently inspect the plate. Particularly, in polychromatic printing, it is important in a printing operation to determine whether or not a register mark is drawn. Therefore, for on-machine development-type lithographic printing plate precursors, there is a demand for means for checking an image, that is, the formation of a so-called print-out image in which an exposed portion develops or does not develop a color at the end of image exposure.

As means for forming the print-out image, WO2016/027886A describes a color developing composition containing a compound having a specific structure capable of forming a print-out image using an infrared ray or heat and describes that this color developing composition develops a color at a high density after image exposure and the color does not fade to a small extent over time. An image-recording layer in the lithographic printing plate precursor described in WO2016/027886A contains a polymerization initiator and a polymerizable compound and forms an image area by radical polymerization. However, the compound having a specific structure which is capable of forming the print-out image has an action of impairing radical polymerization and tends to suppress the curing of the image area. That is, the color developing composition described in WO2016/027886A has excellent visibility (plate inspection property), but has a problem with the printing resistance.

JP2008-544322A describes a thermosensitive image-forming element containing an IR dye having a specific structure which is used for an image-forming layer in an on-machine development-type lithographic printing plate precursor (thermal fusion-type) in which an image area is formed by the fusion or agglomeration of hydrophobic thermoplastic polymer particles by heat and describes that the thermosensitive image-forming element containing an IR dye having a specific structure is capable of forming a print-out image having a high contrast by image exposure. However, in order for the IR dye having a specific structure to achieve the high contrast, the thermosensitive image-forming element needs to contain the IR dye in a coating at a high density or it is necessary to increase the exposure energy during image exposure. In a case in which the IR dye is contained at a high density, at the time of removing a non-exposed portion on a printer using dampening water or printing ink, the dampening water or the printing ink is contaminated by the IR dye, and consequently, a non-image area of a printed matter is contaminated. Meanwhile, in a case in which the exposure energy is increased, the surface of the image-forming layer is desorbed and scattered (ablation), and thus the inside of a stepper is contaminated. That is, the on-machine development-type lithographic printing plate precursor in which the thermosensitive image-forming element described in JP2008-544322A is used has an improved visibility, but has a problem of the contamination of dampening water or printing ink and the consequent contamination of a non-image area of a printed matter or a problem of the contamination of the inside of a stepper.

EP 1 428 676 A2 relates to a printing plate material capable of being developed on a printing press, which comprises an aluminum support and an image formation layer. The image formation layer contains thermoplastic particles and a light-to-heat conversion dye and changes in color due to infrared laser exposure. EP 2 072 570 A1 describes a lithographic printing plate precursor comprising a coating provided on a support having a hydrophilic surface, in which the coating contains thermoplastic polymer particles and an IR-dye having a specific molecular structure. WO 2006/005688 A1 relates to a method for making a negative-working heat-sensitive lithographic printing plate precursor, which comprises the steps of (i) providing a support having a hydrophilic surface and (ii) applying on the support a coating comprising a product DQ, wherein DQ is obtained by the step of coating a solution or dispersion comprising a nucleophilic compound Q and a dye D selected from dyes consisting of di- or tri-arylmethane dyes, cyanine dyes, styryl dyes and merostyryl dyes.

## SUMMARY OF THE INVENTION

An object of the present invention is to provide a thermal fusion-type lithographic printing plate precursor in which the visibility is excellent, ablation during laser exposure is suppressed, and the contamination of dampening water or printing ink during on-machine development is suppressed.

Another object of the present invention is to provide a plate-making method using the lithographic printing plate precursor.

The objects of the present invention are achieved by a lithographic printing plate precursor described below and a plate-making method using the lithographic printing plate. The subject-matter of the present invention is defined in claims 1 to 7.

According to the present invention, a thermal fusion-type lithographic printing plate precursor in which the visibility is excellent, ablation during laser exposure is suppressed, and the contamination of dampening water or printing ink during on-machine development is suppressed is obtained. In addition, a plate-making method using the lithographic printing plate precursor is obtained.

## DESCRIPTION OF THE PREFERRED EMBODIMENTS

Hereinafter, the present invention will be described in detail.

In the present specification, the term "(meth)acrylate" refers to "at least one of acrylate and methacrylate". What has been described above shall apply to "a (meth)acryloyl group", "a (meth)acrylic acid", "a (meth)acrylic resin", and the like.

[Lithographic printing plate precursor]

A lithographic printing plate precursor of the embodiment of the invention has a support and an image-recording layer, the image-recording layer is capable of forming an image by infrared laser exposure, a non-exposed portion of the image-recording layer is removable by at least one of dampening water and printing ink on a printer, and the image-recording layer contains (1) a color developing system in which a hue change generated by infrared laser exposure is $\Delta a/\Delta b \geq$:0.6 and (2) 70% by mass or more of a thermoplastic polymer particle with respect to a solid content of the image-recording layer. The color developing system is described in claim 1 in more detail.

A lithographic printing plate can be produced by on-machine development in which image exposure by an infrared laser is carried out on the lithographic printing plate precursor of the embodiment of the invention and then a non-exposed portion of the image-recording layer is removed by supplying at least one of dampening water and printing ink on a printer.

[Image-recording layer]

The image-recording layer in the lithographic printing plate precursor of the embodiment of the invention is capable of forming an image by infrared laser exposure and has a characteristic that a non-exposed portion of the image-recording layer is removable by at least one of dampening water and printing ink on a printer. Furthermore, the image-recording layer contains (1) a color developing system in which a hue change generated by infrared laser exposure is $\Delta a/\Delta b \geq 0.6$ and (2) 70% by mass or more of a thermoplastic polymer particle with respect to the solid content of the image-recording layer. The components that the image-recording layer contains will be described below.

[(1) Color developing system in which hue change generated by infrared laser exposure is $\Delta a/\Delta b \geq 0.6$]

(1) The color developing system in which a hue change generated by infrared laser exposure is Aa/Ab>0.6 which is included in the image-recording layer of the lithographic printing plate precursor of the embodiment of the invention (hereinafter, also simply referred to as the specific color developing system) is a color developing system in which, in the case of being expressed as a change value of the hue represented by $\Delta a/\Delta b$, a change in the hue generated by infrared laser exposure during the image exposure of the lithographic printing plate precursor reaches 0.6 or more.

The specific color developing system according to the present invention has a characteristic that the change value of the hue $\Delta a/\Delta b$ generated by infrared laser exposure is 0.6 or more. Here, $\Delta a$ and $\Delta b$ correspond to a and b in the CIE 1976 (L*, a*, b*) color space as described below and represent a change value by infrared laser exposure.

$$\Delta a = |(a^* \text{ of non-exposed portion})-(a^* \text{ of exposed portion})|$$

$$\Delta b = |(b^* \text{ of non-exposed portion})-(b^* \text{ of exposed portion})|$$

In addition, $\Delta a/\Delta b$ represents the proportion of a change between red and green and a change between yellow and blue.

Generally, the color difference between a non-exposed portion and an exposed portion is represented by the Euclidean distance $\Delta E$ in a dichromic coordinate as described below. In this relational expression, the influences of $\Delta a$ and $\Delta b$ on the hue change are defined to be identical to each other.

$$\Delta E = [\Delta L^2 + \Delta a^2 + \Delta b^2]^{1/2}$$

However, as a result of verifying the influences on visibility of hue changes by infrared laser exposure using a variety of actual color developing systems, the present inventors clarified that the contribution ratio to visibility between Δa and Δb has a relationship of approximately 10:3, and Δa has a greater effect of improving the visibility than Δb. On the basis of this fact, the present inventors carried out additional studies and consequently found that, in order to view a hue change by infrared laser exposure, Δa/Δb that is the ratio between Δa and Δb needs to be 0.6 or more.

In the present invention, the value of Δa/Δb is more preferably 1.0 or more from the viewpoint of visibility improvement.

The change value of the hue Δa/Δb generated by infrared laser exposure can be computed using the following method.

The lithographic printing plate precursor is exposed using a TRENDSETTER 3244VX manufactured by Creo Co., Ltd. which is equipped with a water cooling-type 40 W infrared semiconductor laser under conditions of a plate surface exposure amount of 150 $mJ/cm^2$ and a resolution of 2,400 dpi. As an exposed image, a 2 cm×2 cm solid image is used.

The hues of the non-exposed portion and the exposed portion of the lithographic printing plate precursor after the exposure are measured in a specular component exclude (SCE) mode using a spectrophotometer CM2600d and operation software CM-S100WS100W manufactured by Konica Minolta, Inc. Δa and Δb are obtained by conversion according to numerical expressions described below on the basis of the L*a*b* values obtained by the measurement, and the change value of the hue Δa/Δb is computed.

$$\Delta L = \text{non-exposed portion } L^* \text{ value} - \text{exposed portion } L^* \text{ value}$$

$$\Delta a = |(\text{non-exposed portion } a^* \text{ value}) - (\text{exposed portion } a^* \text{ value})|$$

$$\Delta b = |(\text{non-exposed portion } b^* \text{ value}) - (\text{exposed portion } b^* \text{ value})|$$

Here, Δa and Δb are absolute values.

The specific color developing system according to the present invention needs to be a color developing system in which the hue change generated by infrared laser exposure is Δa/Δb≥0.6. As specific examples of the specific color developing system, (A) a color developing system formed of an infrared absorbing dye (hereinafter, also referred to as the color developing system A) and (B) a color developing system in which an infrared absorbing dye and a color developing precursor are jointly used (hereinafter, also referred to as the color developing system B) are exemplified. The color developing system A is not in accordance with the present invention.

[Color developing system A] (not in accordance with the present invention)

In the color developing system A, as the infrared absorbing dye, a compound that develops a color by heat and/or exposure to an infrared ray is used.

The infrared absorbing dye that is used in the color developing system A, a compound represented by Formula (1) is preferred.

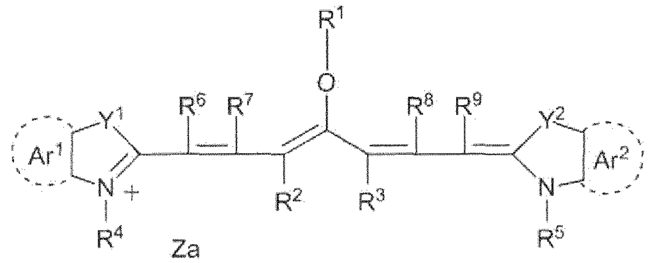

(1)

in Formula (1), $R^1$ represents a group in which an $R^1$-O bond is cleaved by heat or exposure to an infrared ray, $R^2$ and $R^3$ each independently represent a hydrogen atom or an alkyl group, $R^2$ and $R^3$ may be linked to each other to form a ring, $Ar^1$ and $Ar^2$ each independently represent a group forming a benzene ring or a naphthalene ring, $Y^1$ and $Y^2$ each independently represent an oxygen atom, a sulfur atom, $-NR^0-$, or a dialkyl methylene group, $R^4$ and $R^5$ each independently represent an alkyl group, $R^6$ to $R^9$ each independently represent a hydrogen atom or an alkyl group, $R^0$

represents a hydrogen atom, an alkyl group, or an aryl group, and Za represents a counter ion that neutralizes a charge.

<Compound represented by Formula (1)>

The compound represented by Formula (1) is a compound which is decomposed by heat or exposure to an infrared ray and generates a color developing decomposition product.

In the present invention, color development refers to the fact that stronger coloration or absorption occurs at shorter wavelengths after heating or exposure to an infrared ray than before heating and exposure to an infrared ray and absorption occurs in the visible light range. The compound represented by Formula (1) is preferably a compound which is decomposed by heat or exposure to an infrared ray and has a maximum absorption wavelength in a range of 500 to 600 nm.

The color development mechanism of the compound represented by Formula (1) is assumed as follows: the $R^1$-O bond is cleaved by heat or exposure to an infrared ray, the cleaved oxygen atoms form a carbonyl group, and a merocyanine colorant which is a color developing body is generated, and color is developed.

In addition, in order to generate the merocyanine colorant, it is assumed that the bonding between $R^1$ in which the bond is cleaved by heat or exposure to an infrared ray and a cyanine colorant structure through an oxygen atom is important.

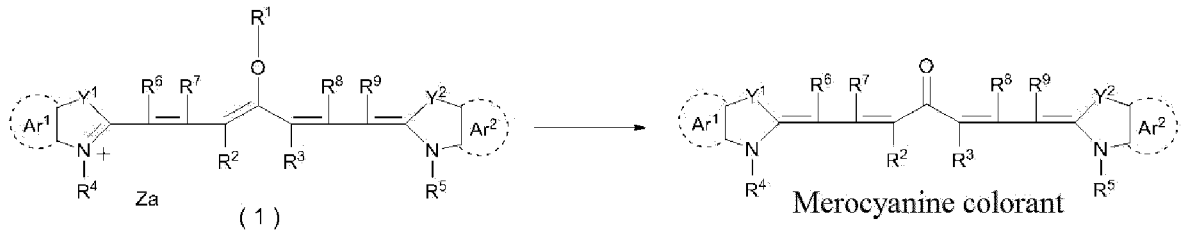


$R^1$ represents a group in which the $R^1$-O bond is cleaved by heat or exposure to an infrared ray. Specific examples thereof include a group in which the decomposition or isomerization reaction of the compound represented by Formula (1) proceeds due to heat energy supplied from the outside, energy generated in a case in which the compound returns to the ground state from the excited state generated by the absorption of an infrared ray, or a chemical reaction proceeding from the excited state and the $R^1$-O bond is cleaved.

A preferred aspect of $R^1$ will be described below.

The alkyl group as $R^2$ to $R^9$ and $R^0$ is preferably an alkyl group having 1 to 30 carbon atoms, more preferably an alkyl group having 1 to 15 carbon atoms, and still more preferably an alkyl group having 1 to 10 carbon atoms. The alkyl group may have a linear shape or a branch and may have a ring structure.

Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group.

Among these alkyl groups, a methyl group, an ethyl group, a propyl group, and a butyl group are particularly preferred.

In addition, the alkyl group may have a substituent. Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, a group formed of a combination thereof, and the like.

The aryl group as $R^0$ is preferably an aryl group having 6 to 30 carbon atoms, more preferably an aryl group having 6 to 20 carbon atoms, and still more preferably an aryl group having 6 to 12 carbon atoms.

In addition, the aryl group may have a substituent. Examples of the substituent include an alkyl group, an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, a group formed of a combination thereof, and the like.

Specific examples thereof include a phenyl group, a naphthyl group, a p-tolyl group, a p-chlorophenyl group, a p-fluorophenyl group, a p-methoxyphenyl group, a p-dimethylaminophenyl group, a p-methyl thiophenyl group, a p-phenylthiophenyl group, and the like.

Among these aryl groups, a phenyl group, a p-methoxyphenyl group, a p-dimethylaminophenyl group, or a naphthyl group is preferred.

$R^2$ and $R^3$ are preferably linked to each other to form a ring.

In a case in which $R^2$ and $R^3$ are linked to each other to form a ring, a five-membered ring or a six-membered ring is preferred, and a five-membered ring is particularly preferred.

$Y^1$ and $Y^2$ each independently represent an oxygen atom, a sulfur atom, $-NR^0-$, or a dialkyl methylene group and are preferably $-NR^0-$ or a dialkyl methylene group and more preferably a dialkyl methylene group.

$R^0$ represents a hydrogen atom, an alkyl group, or an aryl group and is preferably an alkyl group.

$R^4$ and $R^5$ are preferably identical groups.

In addition, $R^4$ and $R^5$ each are independently preferably a linear alkyl group or an alkyl group having a sulfonate group at the terminal and more preferably a methyl group, an ethyl group, or a butyl group having a sulfonate group at the terminal.

In addition, a counter cation of the sulfonate group may be a quaternary ammonium group in Formula (1), an alkali metal cation, or an alkaline earth metal cation.

Furthermore, from the viewpoint of improving the water solubility of the compound represented by Formula (1), $R^4$ and $R^5$ each are independently preferably an alkyl group having an anion structure, more preferably an alkyl group having a carboxylate group or a sulfonate group, and still more preferably an alkyl group having a sulfonate group at the terminal.

In addition, from the viewpoint of an increase in the maximum absorption wavelength of the compound represented by Formula (1) and color developability and printing resistance in lithographic printing plates, $R^4$ and $R^5$ each are independently preferably an alkyl group having an aromatic ring, more preferably an alkyl group having an aromatic ring at the terminal, and particularly preferably a 2-phenyl ethyl group, a 2-naphthalenylethyl group, or a 2-(9-anthracenyl)ethyl group.

$R^6$ to $R^9$ each independently represent a hydrogen atom or an alkyl group and are preferably a hydrogen atom.

$Ar^1$ and $Ar^2$ each independently represent a group forming a benzene ring or a naphthalene ring. The benzene ring or the naphthalene ring may have a substituent. Examples of the substituent include an alkyl group, an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, a group formed of a combination thereof, and the like, and an alkyl group is preferred.

In addition, from the viewpoint of an increase in the maximum absorption wavelength of the compound represented by Formula (1) and color developability and printing resistance in lithographic printing plates, $Ar^1$ and $Ar^2$ each are independently preferably a group forming a naphthalene ring or a benzene ring having an alkyl group or an alkoxy group as a substituent, more preferably a group forming a naphthalene ring or a benzene ring having an alkoxy group as a substituent, and particularly preferably a group forming a naphthalene ring or a benzene ring having a methoxy group as a substituent.

Za represents a counter ion that neutralizes a charge, and, in the case of representing an anion, examples thereof include a sulfonate ion, a carboxylate ion, a tetrafluoroborate ion, a hexafluorophosphate ion, a p-toluenesulfonate ion, a perchlorate ion, and the like, and a hexafluorophosphate ion is particularly preferred. In the case of representing a cation, Za is preferably an alkali metal ion, an alkaline earth metal ion, an ammonium ion, a pyridinium ion, a sulfonium ion, more preferably a sodium ion, a potassium ion, an ammonium ion, a pyridinium ion, or a sulfonium ion, and still more preferably a sodium ion, a potassium ion, or an ammonium ion.

$R^1$ to $R^9$, $R^0$, $Ar^1$, $Ar^2$, $Y^1$, and $Y^2$ may have an anion structure or a cation structure, and, in a case in which all of $R^1$ to $R^9$, $R^0$, $Ar^1$, $Ar^2$, $Y^1$, and $Y^2$ are electrically neutral groups, Za is a monovalent counter anion, and, for example, in a case in which $R^1$ to $R^9$, $R^0$, $Ar^1$, $Ar^2$, $Y^1$, and $Y^2$ have two or more anion structures, Za may also become a counter cation.

From the viewpoint of color developability, $R^1$ is preferably a group represented by any of Formulae 1-1 to 1-7 and more preferably a group represented by any of Formulae 1-1 to 1-3.

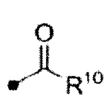
(1-1)

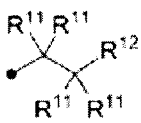
(1-2)

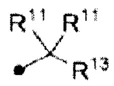
(1-3)

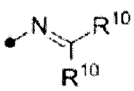
(1-4)

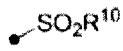
(1-5)

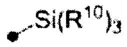
(1-6)

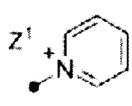
(1-7)

In Formulae 1-1 to 1-7, • represents a bonding site with the oxygen atom in Formula (1), $R^{10}$'s each independently represent a hydrogen atom, an alkyl group, an alkenyl group, an aryl group, $-OR^{14}$, $-NR^{15}R^{16}$, or $-SR^{17}$, $R^{11}$'s each independently represent a hydrogen atom, an alkyl group, or an aryl group, $R^{12}$ represents an aryl group, $-OR^{14}$, $-NR^{15}R^{16}$, $-SR^{17}$, $-C(=O)R^{18}$, $-OC(=O)R^{18}$, or a halogen atom, $R^{13}$ represents an aryl group, an alkenyl group, an alkoxy group, or an onium group, $R^{14}$ to $R^{17}$ each independently represent a hydrogen atom, an alkyl group, or an aryl group, $R^{18}$ represents an alkyl group, an aryl group, $-OR^{14}$, $-NR^{15}R^{16}$, or $-SR^{17}$, and $Z^1$ represents a counter ion that neutralizes a charge.

In a case in which $R^{10}$, $R^{11}$, and $R^{14}$ to $R^{18}$ are alkyl groups, the preferred aspects thereof are identical to the preferred aspects of the alkyl group as $R^2$ to $R^9$ and $R^0$.

The number of carbon atoms in the alkenyl group as $R^{10}$ and $R^{13}$ is preferably 1 to 30, more preferably 1 to 15, and still more preferably 1 to 10.

In a case in which $R^{10}$ to $R^{18}$ are aryl groups, the preferred aspects thereof are identical to the preferred aspects of the aryl group as $R^0$.

From the viewpoint of color developability, $R^{10}$ in Formula 1-1 is preferably an alkyl group, an alkenyl group, an aryl group, $-OR^{14}$, $-NR^{15}R^{16}$, or $-SR^{17}$, more preferably an alkyl group, $-OR^{14}$, $-NR^{15}R^{16}$, or $-SR^{17}$, still more preferably an alkyl group or $-OR^{14}$, and particularly preferably $-OR^{14}$.

In addition, in a case in which $R^{10}$ in Formula (1-1) is an alkyl group, the alkyl group may be an alkyl group having an arylthio group, an alkyloxycarbonyl group, or an arylsulfonyl group at the $\alpha$-position and is preferably an alkyl group having an arylthio group or an alkyloxycarbonyl group at the $\alpha$-position.

In a case in which $R^{10}$ in Formula 1-1 is $-OR^{14}$, $R^{14}$ is preferably an alkyl group, more preferably an alkyl group having 1 to 8 carbon atoms, still more preferably an isopropyl group or a tert-butyl group, and particularly preferably a t-butyl group.

From the viewpoint of color developability, $R^{11}$ in Formula 1-2 is preferably a hydrogen atom.

In addition, from the viewpoint of color developability, $R^{12}$ in Formula 1-2 is preferably $-C(=O)OR^{14}$, $-OC(=O)OR^{14}$, or a halogen atom and more preferably $-C(=O)OR^{14}$ or $-OC(=O)OR^{14}$. In a case in which $R^{12}$ in Formula 1-2 is $-C(=O)OR^{14}$ or $-OC(=O)OR^{14}$, $R^{14}$ is preferably an alkyl group.

From the viewpoint of color developability, $R^{11}$'s in Formula 1-3 each are independently preferably a hydrogen atom or an alkyl group, and at least one $R^{11}$ in Formula 1-3 is more preferably an alkyl group.

In addition, the alkyl group as $R^{11}$ is preferably an alkyl group having 1 to 10 carbon atoms and more preferably an alkyl group having 3 to 10 carbon atoms.

Furthermore, the alkyl group as $R^{11}$ is preferably an alkyl group having a branch, more preferably a secondary or tertiary alkyl group, and still more preferably an isopropyl group, a cyclopentyl group, a cyclohexyl group, or a tert-butyl group.

In addition, from the viewpoint of color developability, $R^{13}$ in Formula 1-3 is preferably an aryl group, an alkoxy group, or an onium group, more preferably p-dimethylaminophenyl group or a pyridinium group, and still more preferably a pyridinium group.

Examples of the onium group as $R^{13}$ include a pyridinium group, an ammonium group, a sulfonium group, and the like. The onium group may have a substituent. Examples of the substituent include an alkyl group, an alkoxy group, an aryloxy group, an amino group, an alkylthio group, an arylthio group, a halogen atom, a carboxy group, a sulfo group, an alkyloxycarbonyl group, an aryloxycarbonyl group, a group formed of a combination thereof, and the like, and an alkyl group, an aryl group, and a group formed of a combination thereof are preferred.

Among these, a pyridinium group is preferred, an N-alkyl-3-pyridinium group, an N-benzyl-3-pyridinium group, an N-(alkoxy polyalkyleneoxy alkyl)-3-pyridinium group, an N-alkoxycarbonylmethyl-3-pyridinium group, an N-alkyl-4-pyridinium group, an N-benzyl-4-pyridinium group, an N-(alkoxy polyalkyleneoxy alkyl)-4-pyridinium group, an N-alkoxycarbonylmethyl-4-pyridinium group, or an N-alkyl-3,5-dimethyl-4-pyridinium group is more preferred, an N-alkyl-3-pyridinium group or an N-alkyl-4-pyridinium group is still more preferred, an N-methyl-3-pyridinium group, an N-octyl-3-pyridinium group, an N-methyl-4-pyridinium group, or an N-octyl-4-pyridinium group is particularly preferred, and an N-octyl-3-pyridinium group or an N-octyl-4-pyridinium group is most preferred.

In addition, in a case in which $R^{13}$ is a pyridinium group, examples of the counter anion include a sulfonate ion, a carboxylate ion, a tetrafluoroborate ion, a hexafluorophosphate ion, a p-toluenesulfonate ion, a perchlorate ion, and the like, and a p-toluenesulfonate ion or a hexafluorophosphate ion is preferred.

From the viewpoint of color developability, $R^{10}$'s in Formula 1-4 are preferably alkyl groups or aryl groups, and it is more preferable that one of the two $R^{10}$'s is an alkyl group and the other is an aryl group.

From the viewpoint of color developability, $R^{10}$ in Formula 1-5 is preferably an alkyl group or an aryl group, more preferably an aryl group, and still more preferably a p-methylphenyl group.

From the viewpoint of color developability, $R^{10}$'s in Formula 1-6 each are independently preferably alkyl groups or aryl groups and more preferably methyl groups or phenyl groups.

From the viewpoint of color developability, $Z^1$ in Formula 1-7 may be a counter ion that neutralizes a charge

and may be included in Za as the entire compound.

$Z^1$ is preferably a sulfonate ion, a carboxylate ion, a tetrafluoroborate ion, a hexafluorophosphate ion, a p-toluenesulfonate ion, or a perchlorate ion and more preferably a p-toluenesulfonate ion or a hexafluorophosphate ion.

In addition, $R^1$ is particularly preferably a group represented by Formula 2.

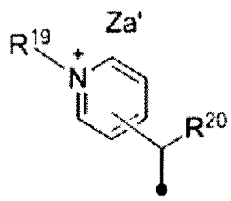

In Formula 2, • represents a bonding site with the oxygen atom in Formula (1), $R^{19}$ and $R^{20}$ each independently represent an alkyl group, and Za' represents a counter ion that neutralizes a charge.

The bonding position with a hydrocarbon group including a pyridinium ring and $R^{20}$ in Formula 2 is preferably the third or fourth position of the pyridinium ring and more preferably the fourth position of the pyridinium ring.

The alkyl group as $R^{19}$ and $R^{20}$ may have a linear shape, a branch, or a ring structure.

In addition, the alkyl group may have a substituent, and preferred examples of the substituent include an alkoxy group and a terminal alkoxy polyalkyleneoxy group.

$R^{19}$ is preferably an alkyl group having 1 to 12 carbon atoms, more preferably a linear alkyl group having 1 to 12 carbon atoms, still more preferably a linear alkyl group having 1 to 8 carbon atoms, and particularly preferably a methyl group or an n-octyl group.

$R^{20}$ is preferably an alkyl group having 1 to 8 carbon atoms, more preferably a branched alkyl group having 3 to 8 carbon atoms, still more preferably an isopropyl group or a t-butyl group, and particularly preferably an isopropyl group.

Za' may be a counter ion neutralizing a charge and may be included in Za as the entire compound.

Za' is preferably a sulfonate ion, a carboxylate ion, a tetrafluoroborate ion, a hexafluorophosphate ion, a p-toluenesulfonate ion, or a perchlorate ion and more preferably a p-toluenesulfonate ion or a hexafluorophosphate ion.

Hereinafter, preferred examples of $R^1$ will be illustrated. Meanwhile, $TsO^-$ represents a tosylate anion.

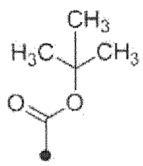
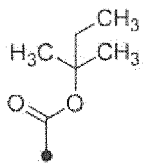
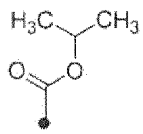
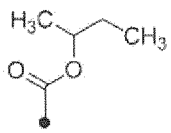
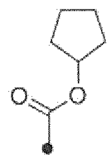

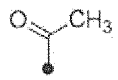
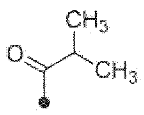
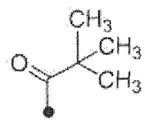
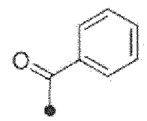

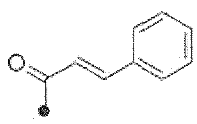
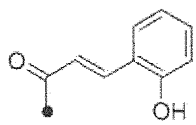
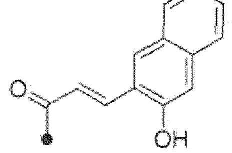

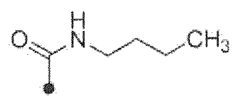
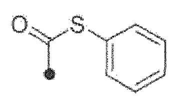

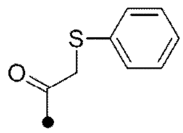
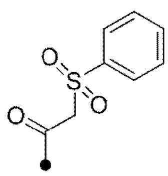
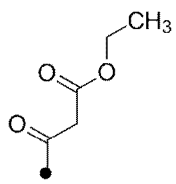

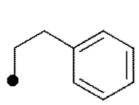
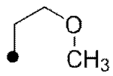
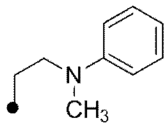
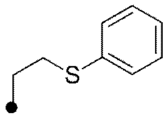
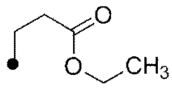
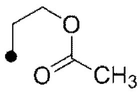
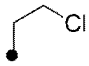
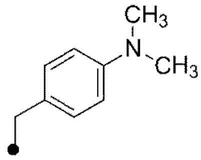
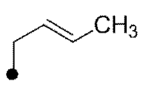
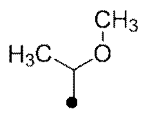
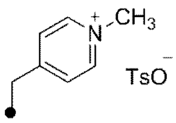
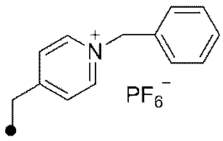
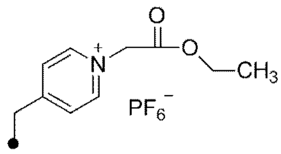
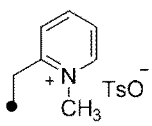
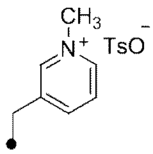
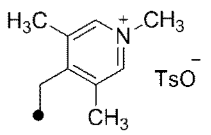
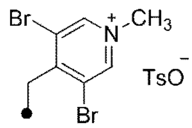
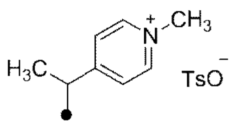
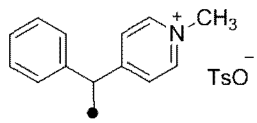
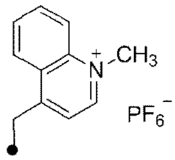
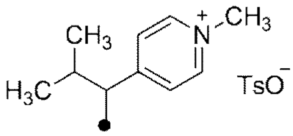
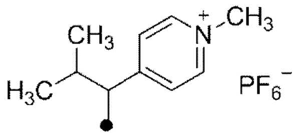
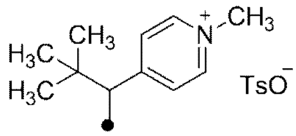
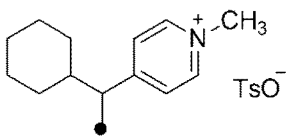
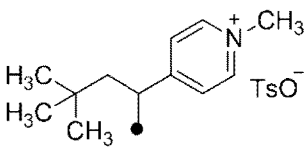
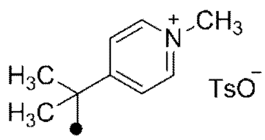
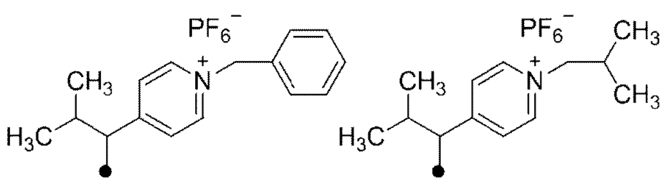
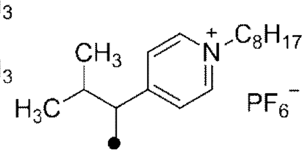

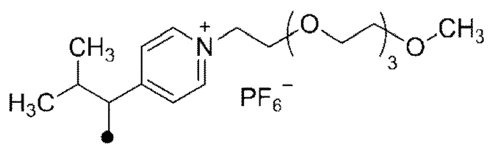

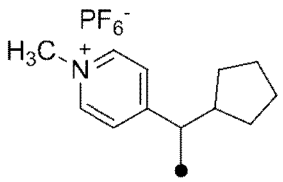
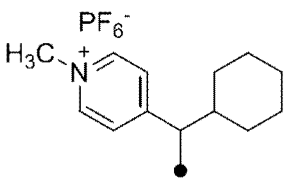
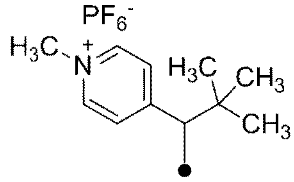

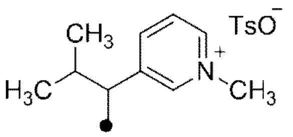
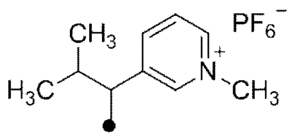
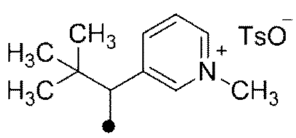

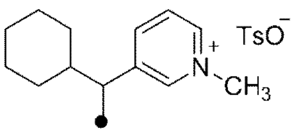
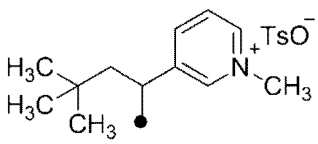
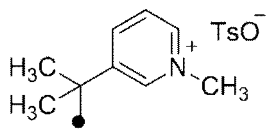

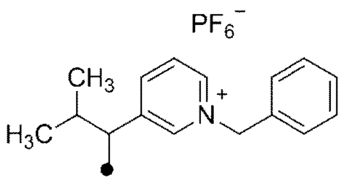
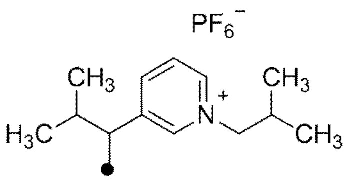
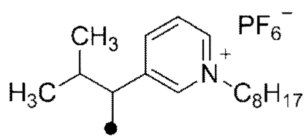

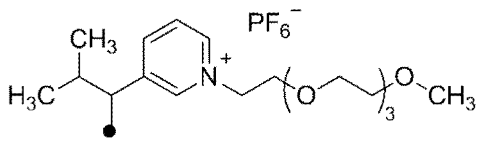

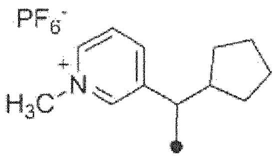
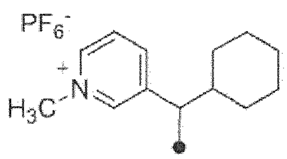
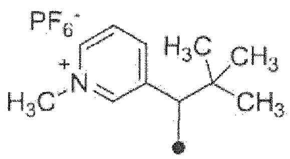

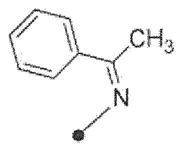
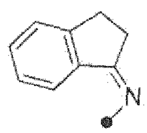

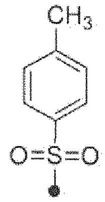
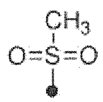
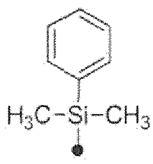
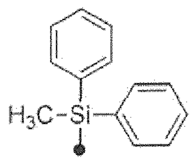

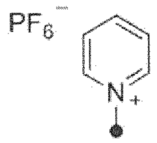

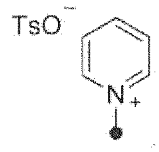

Hereinafter, as specific preferred examples of the compound represented by Formula (1), specific compounds 1 to 45 will be illustrated. In the following specific examples, TsO- represents a tosylate anion.

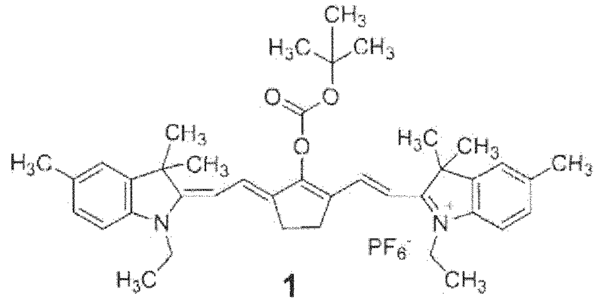

1

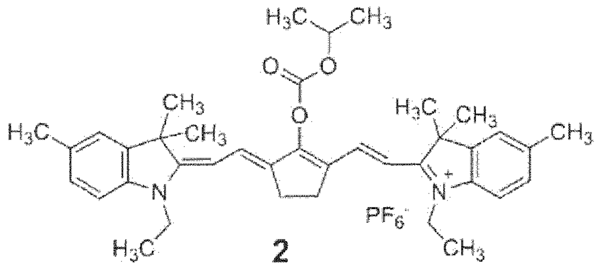

2

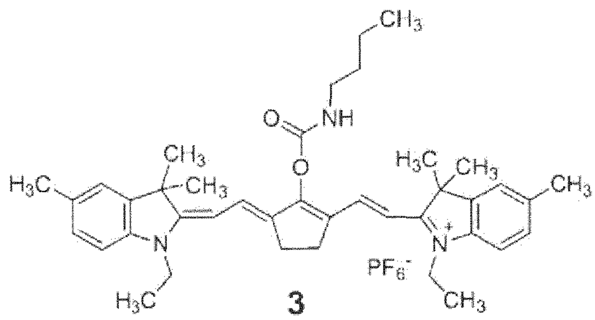

3

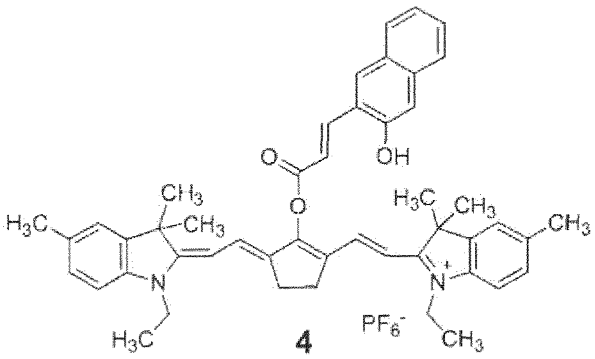

4

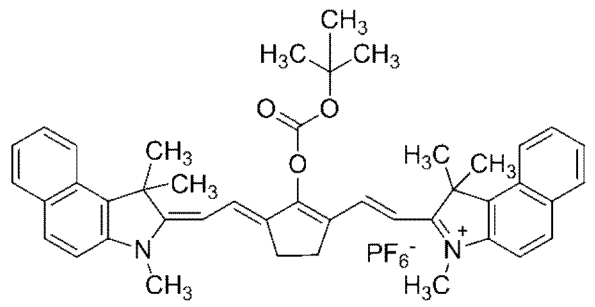

5

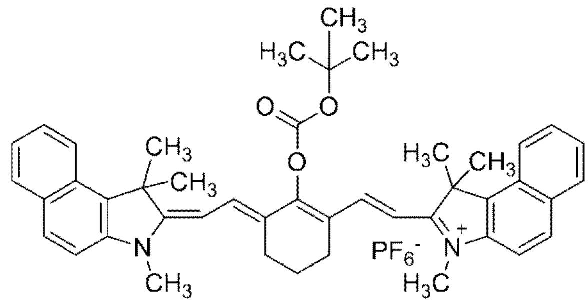

6

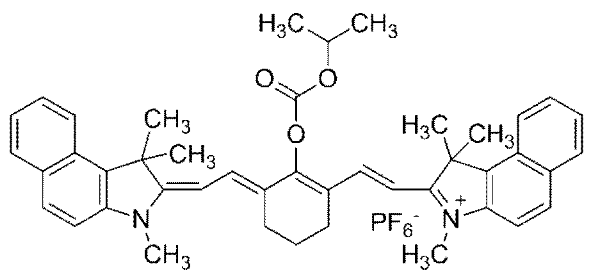

7

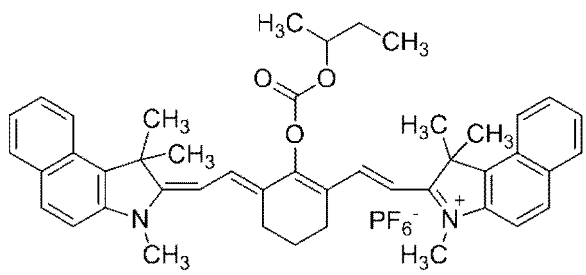

8

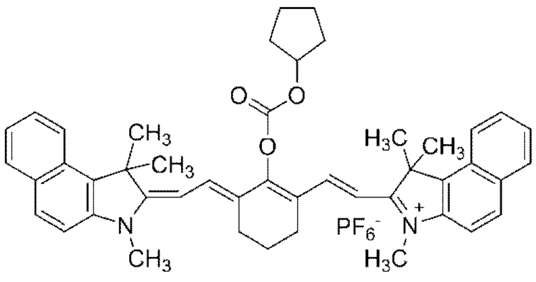

9

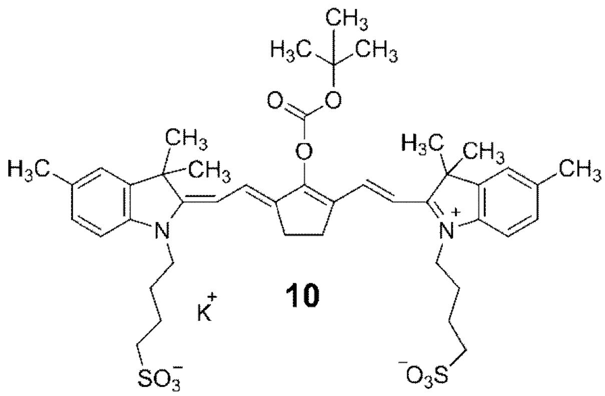

10

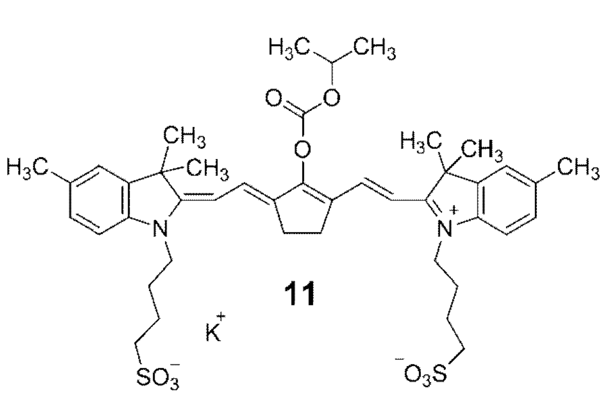

11

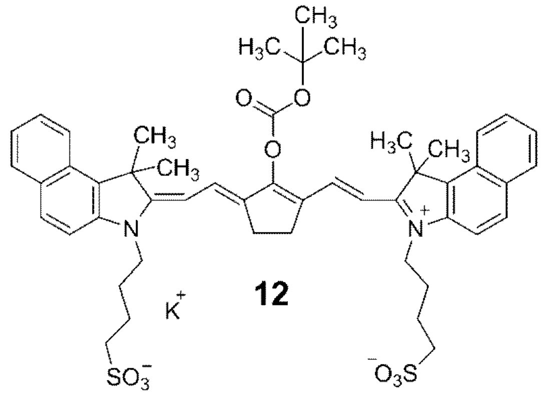

12

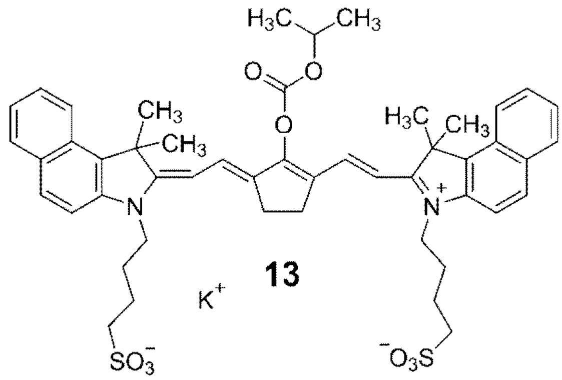

13

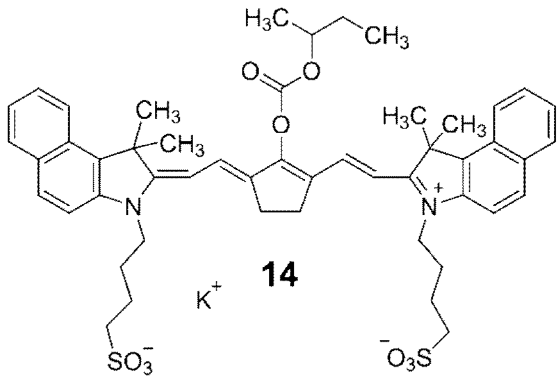

14

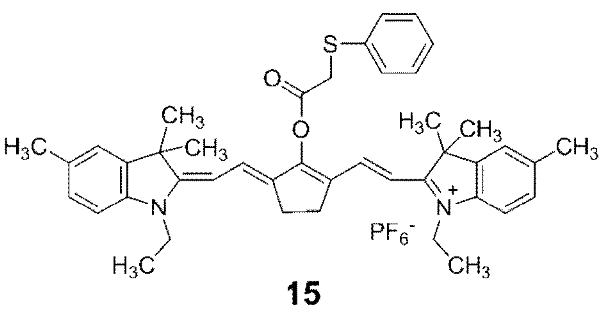

15

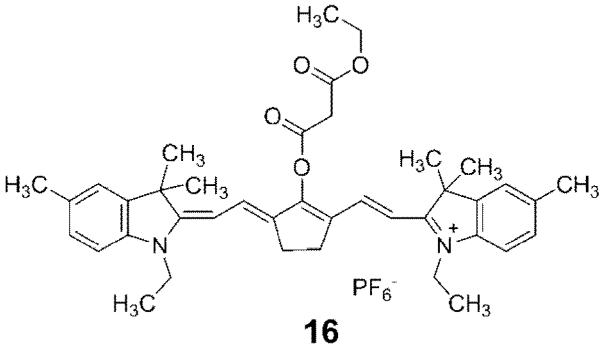

16

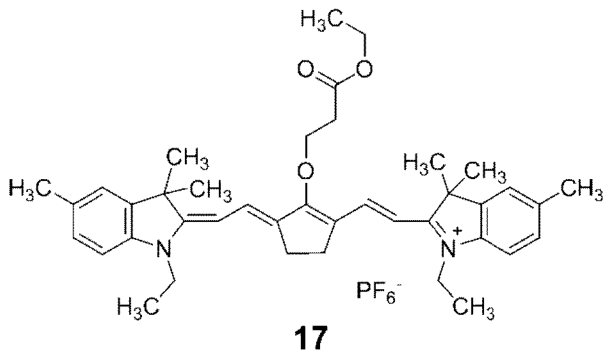

**17**

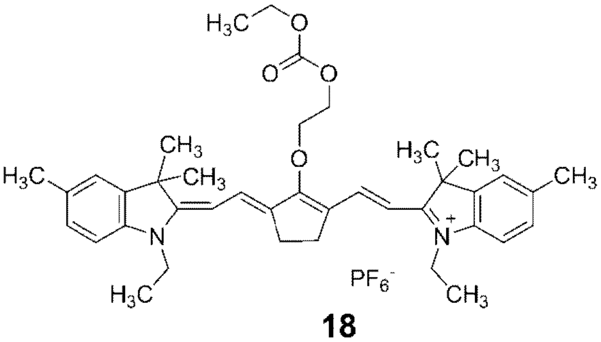

**18**

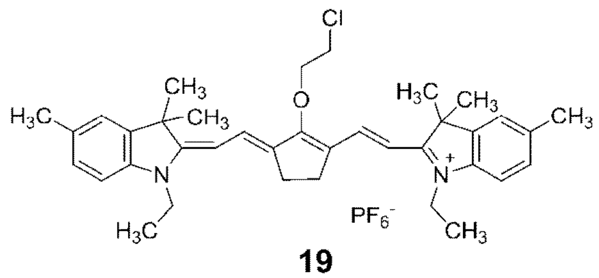

**19**

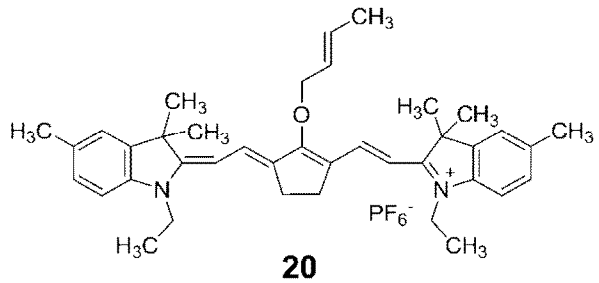

**20**

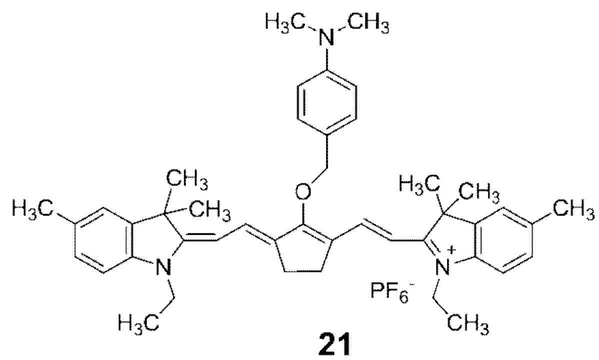

**21**

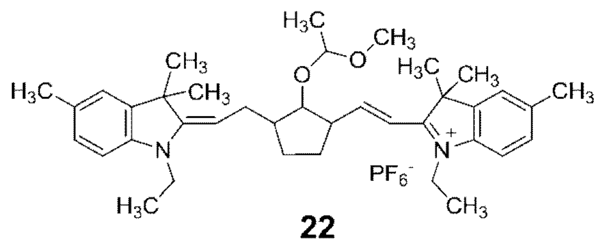

**22**

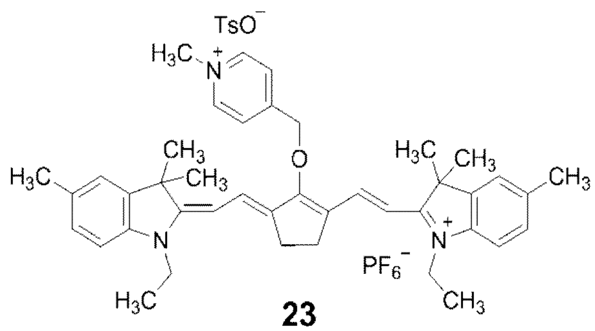

**23**

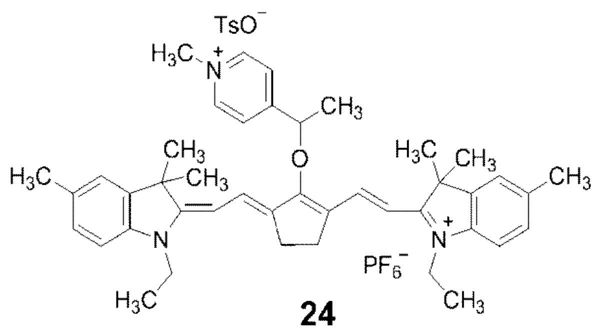

**24**

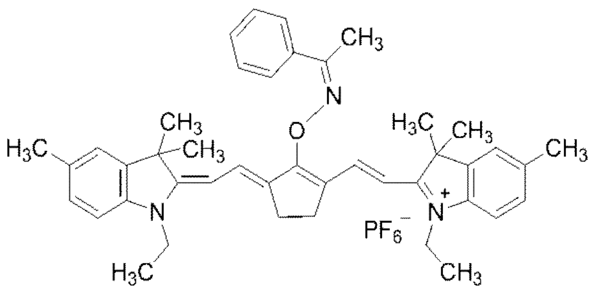

25

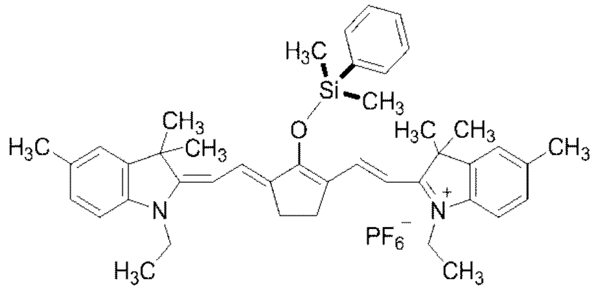

26

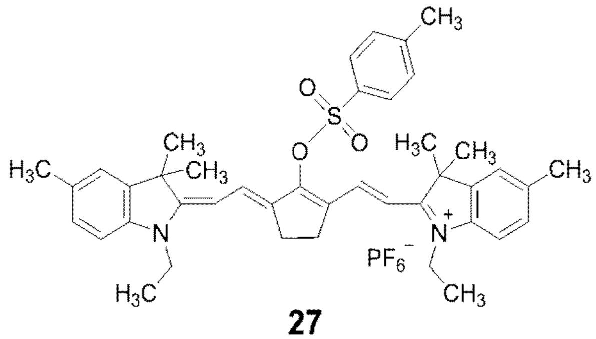

27

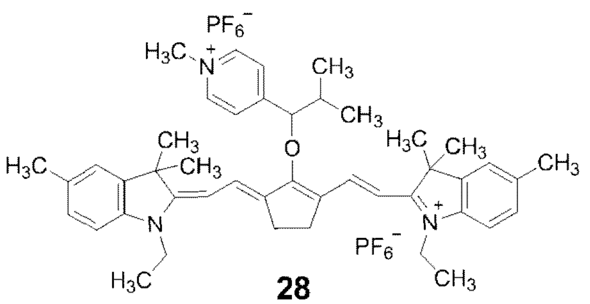

28

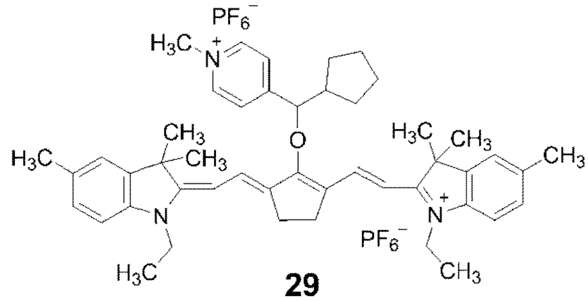

29

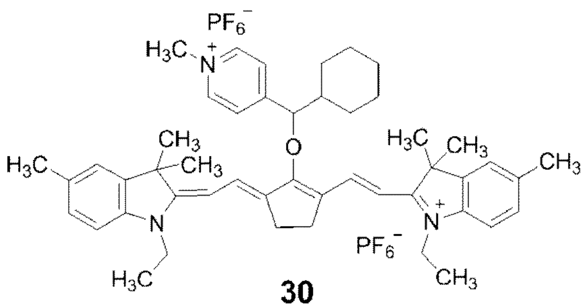

30

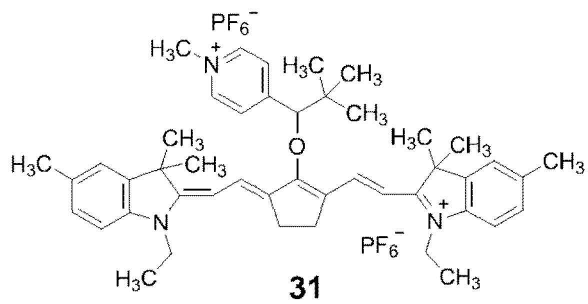

31

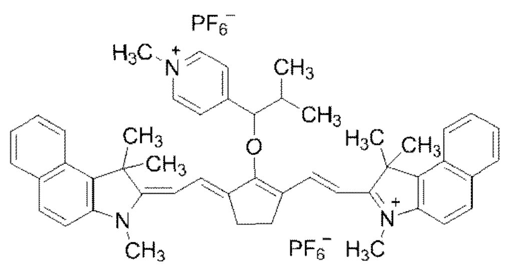

32

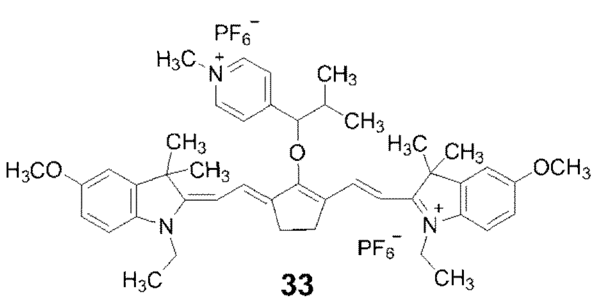

33

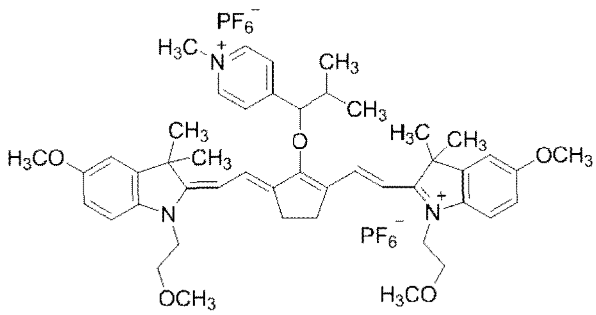

**34**

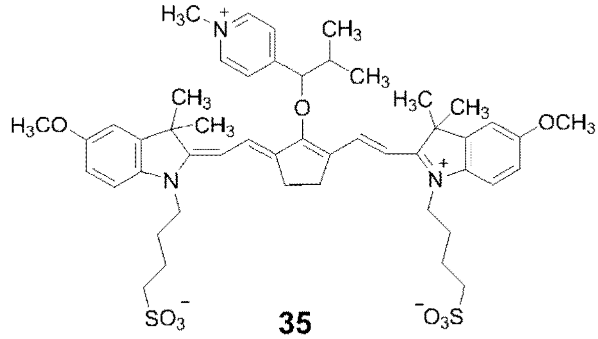

**35**

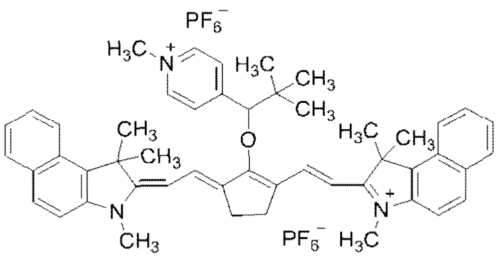

**36**

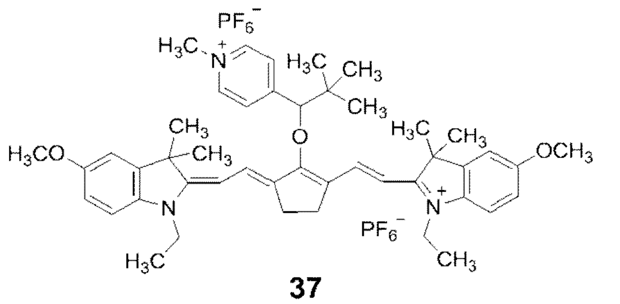

**37**

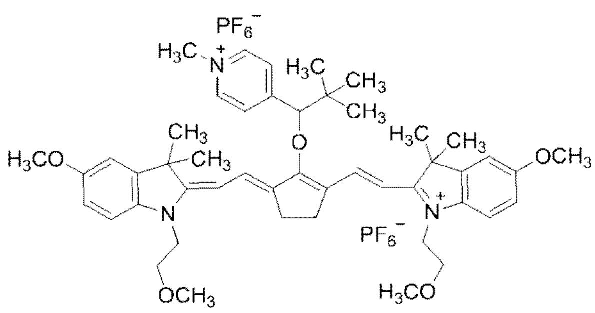

**38**

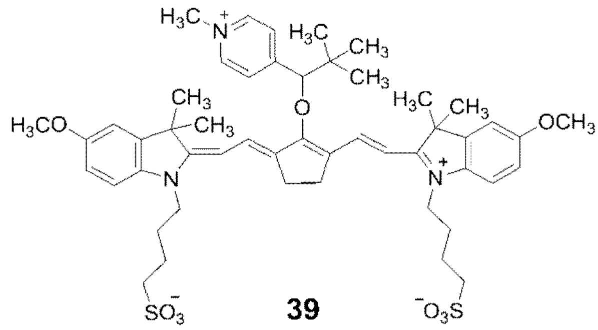

**39**

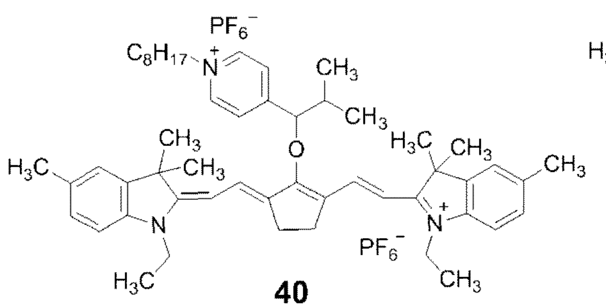

**40**

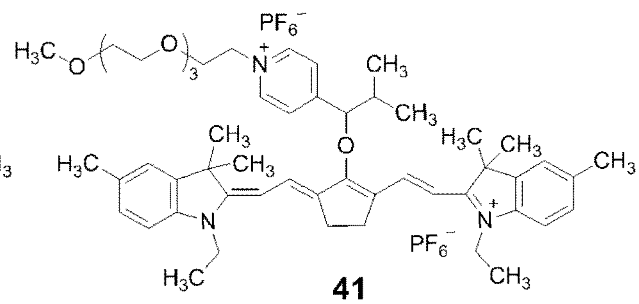

**41**

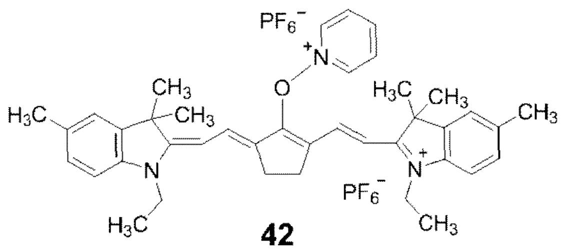

**42**

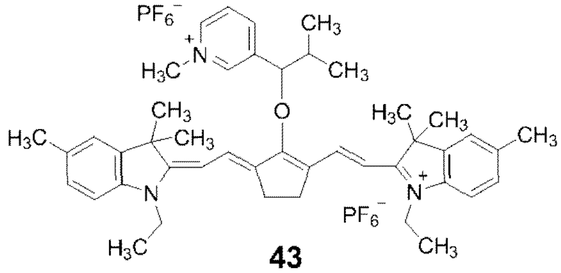

**43**

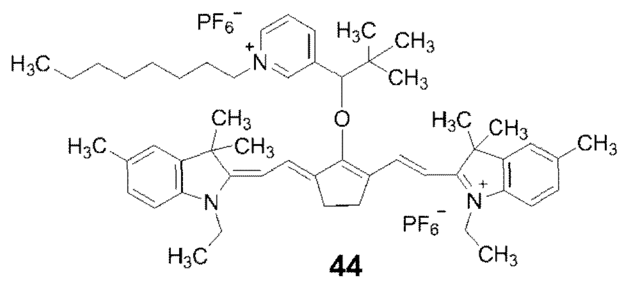

44

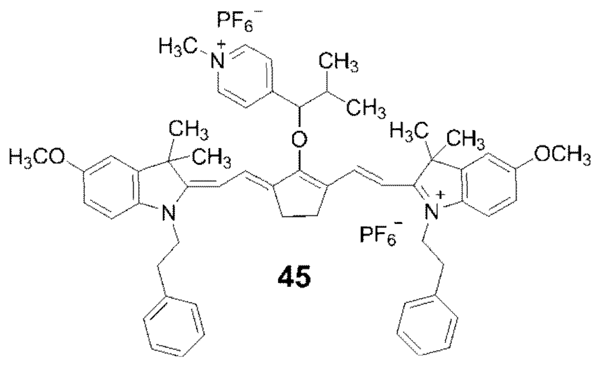

45

As the infrared absorbing dye that is used in the color developing system A, a compound having a cyanine colorant structure represented by General Formula (i) and having at least one solvent-soluble group in a molecule is also preferred.

The solvent-soluble group in the compound refers to an organic functional group capable of improving the solvent solubility of a cyanine colorant, and, preferably, an alkyloxy group, an aryloxy group, an ether group, an alkylcarbonyl group, an arylcarbonyl group, an alkyloxycarbonyl group, an aryloxycarbonyl group, a sulfonylamide group, a carboxyl group, a sulfonyl acid group, a hydroxy group, an alkylcarbonyloxy group, an arylcarbonyl, an amide group, and the like are exemplified. As a more preferred solvent-soluble group, an alkyloxy group, an aryloxy group, an ether group, an alkyloxycarbonyl group, and an aryloxycarbonyl group are exemplified, and, as a particularly preferred solvent-soluble group, an ether group is exemplified.

The solvent-soluble group may be introduced to any location of the cyanine colorant structure represented by General Formula (i), but is preferably introduced to an aromatic hydrocarbon group represented by $Ar^1$ or $Ar^2$, nitrogen atoms at both terminals, Ph (an aromatic ring (a phenyl group)) in a case in which $X^1$ represents $-NPh_2$, or the like. From the viewpoint of improving the on-machine developability, a compound in which the solvent-soluble groups are introduced to nitrogen atoms at both terminals is particularly preferred. The number of the solvent-soluble groups being introduced is at least one, but two to six solvent-soluble groups are preferably introduced to one molecule of the cyanine colorant since it is possible to evenly coat the image-recording layer in a high density state, the generation of gas during on-machine development due to a component in the image-recording layer is suppressed, or the on-machine developability is improved.

General Formula (i)

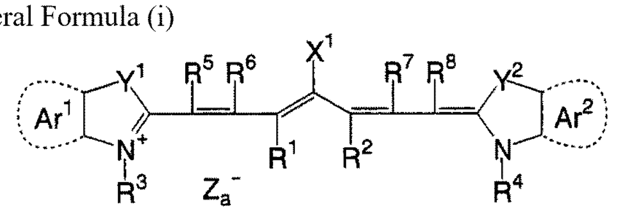

In General Formula (i), $X^1$ represents a hydrogen atom, a halogen atom, $-NPh_2$, $X^2$-$L^1$, or a group described below. Here, $X^2$ represents an oxygen atom, a nitrogen atom, or a sulfur atom, and $L^1$ represents a hydrocarbon group having 1 to 12 carbon atoms or a hydrocarbon group including a hetero atom and having 1 to 12 carbon atoms. Here, the hetero atom represents N, S, O, a halogen atom, or Se. In the group described below, $X_a^-$ is the same as $Z_a^-$ described below, and $R^a$ represents a hydrogen atom or a substituent selected from an alkyl group, an aryl group, a substituted or unsubstituted amino group, and a halogen atom. From the viewpoint of visibility improvement, $X^1$ is preferably $-NPh_2$.

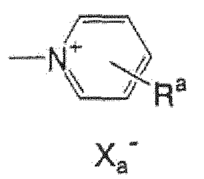

In General Formula (i), $R^1$ and $R^2$ each independently represent a hydrocarbon group having 1 to 12 carbon atoms. From the viewpoint of the storage stability of an image-recording layer coating fluid, $R^1$ and $R^2$ are preferably a hydrocarbon group having 2 or more carbon atoms, and $R^1$ and $R^2$ are preferably bonded to each other to form a five-membered ring or a six-membered ring. From the viewpoint of visibility improvement, $R^1$ and $R^2$ are particularly preferably bonded to each other to form a five-membered ring.

In General Formula (i), $Ar^1$ and $Ar^2$ may be identical to or different from each other and represent an aromatic hydrocarbon group. The aromatic hydrocarbon group may have a substituent. As a preferred aromatic hydrocarbon group, a benzene ring and a naphthalene ring are exemplified. In addition, as a preferred substituent, a hydrocarbon group having 12 or less carbon atoms, a halogen atom, and an alkoxy group having 12 or less carbon atoms are exemplified. From the viewpoint of visibility improvement, an electron-donating group is preferred, and, specifically, an alkoxy group having 12 or less carbon atoms or an alkyl group having 12 or less carbon atoms is more preferred. $Y^1$ and $Y^2$ may be identical to or different from each other and represent a sulfur atom or a dialkyl methylene group having 12 or less carbon atoms. $R^3$ and $R^4$ may be identical to or different from each other and represent a hydrocarbon group having 20 or less carbon atoms. The hydrocarbon group having 20 or less carbon atoms may have a substituent. As a preferred substituent, an alkoxy group having 12 or less carbon atoms, a carboxyl group, and a sulfo group are exemplified. $R^5$, $R^6$, $R^7$, and $R^8$ may be identical to or different from one another and represent a hydrogen atom or a hydrocarbon group having 12 or less carbon atoms. From the viewpoint of the easy procurement of a raw material, a hydrogen atom is preferred. In addition, $Z_a^-$ represents a counter anion. Here, in case the compound having a cyanine colorant structure represented by General Formula (i) has an anionic substituent in the structure and neutralization of a charge is not necessary, $Z_a^-$ is not required. From the viewpoint of the storage stability of the image-recording layer coating fluid, a preferred $Z_a^-$ is a halogen ion, a perchlorate ion, a tetrafluoroborate ion, a hexafluorophosphate ion, or a sulfonic acid ion, and a perchlorate ion, a hexafluorophosphate ion, or an aryl sulfonate ion are particularly preferred. From the viewpoint of visibility improvement, $Z_a^-$ is preferably an inorganic anion or a counter anion of a strong acid. From the above-described viewpoint, $PF_6^-$, $BF_4^-$, $CF_3SO_3^-$, $C_4F_9SO_3^-$ are preferred, and $PF_6^-$ is particularly preferred.

As specific examples of the compound having the cyanine colorant structure represented by General Formula (i) and having at least one solvent-soluble group in a molecule, the following compounds (IR-1) to (IR-32) are exemplified. In the following specific examples, Ac represents an acetyl group.

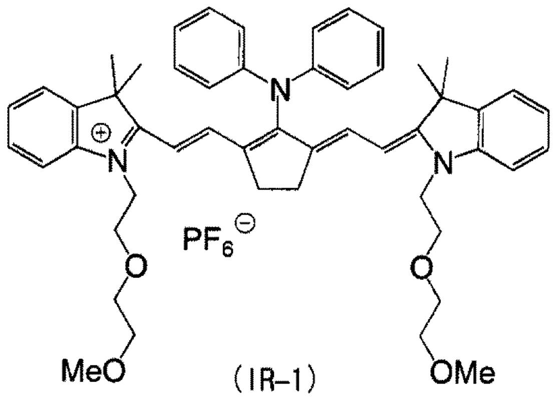

(IR-1)

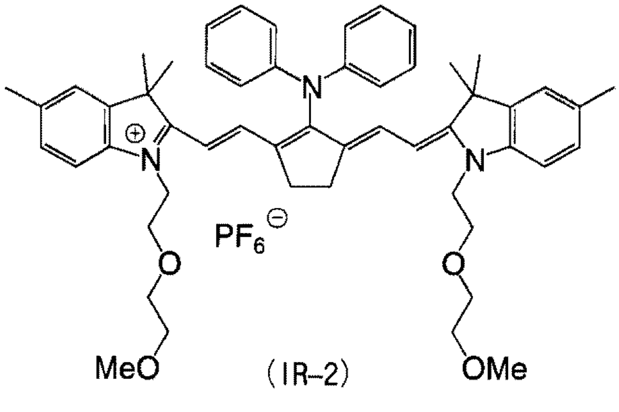

(IR-2)

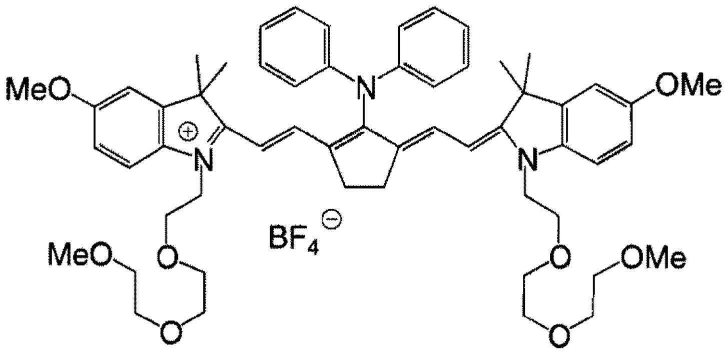

(IR-3)

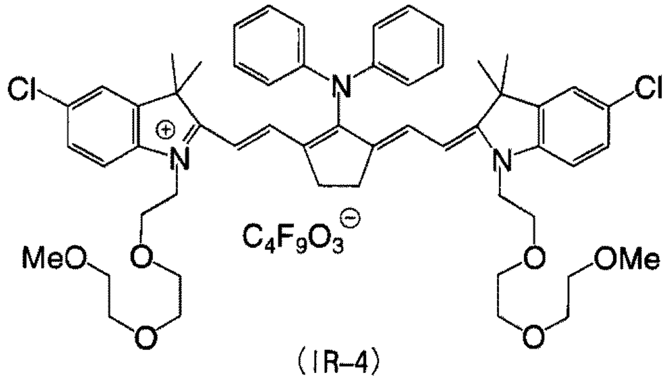

(IR-4)

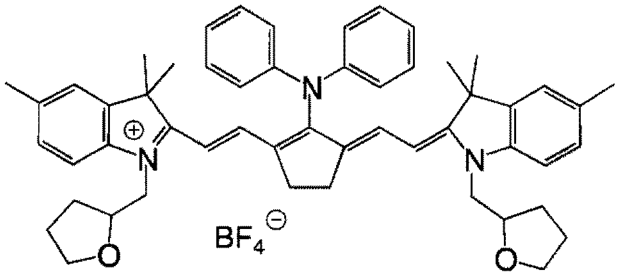

(IR-5)

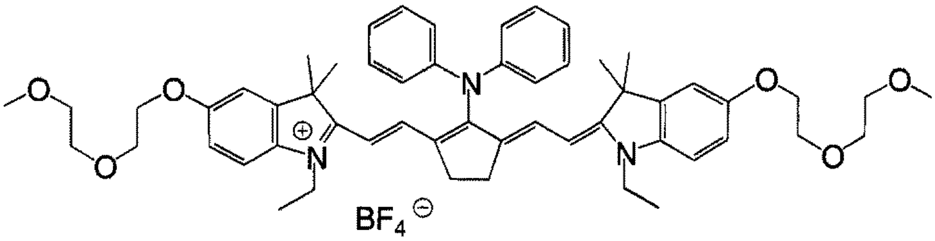

(IR-6)

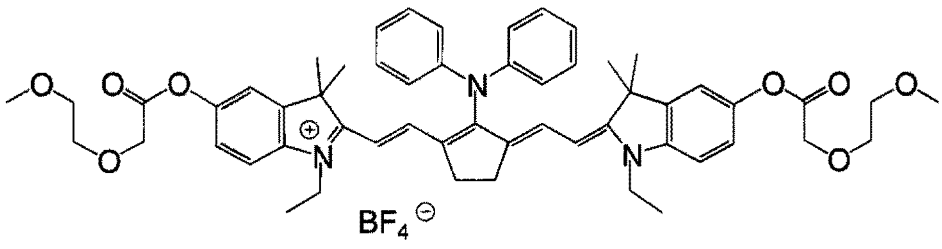

(IR-7)

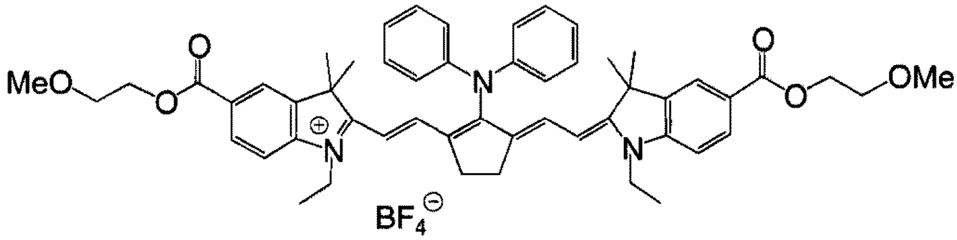

(IR-8)

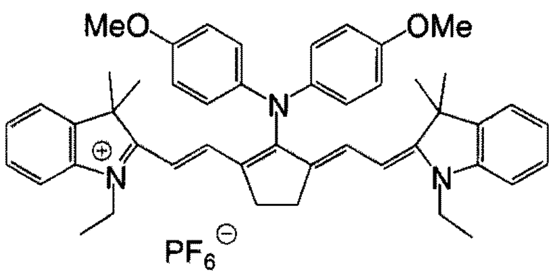

(IR-9)

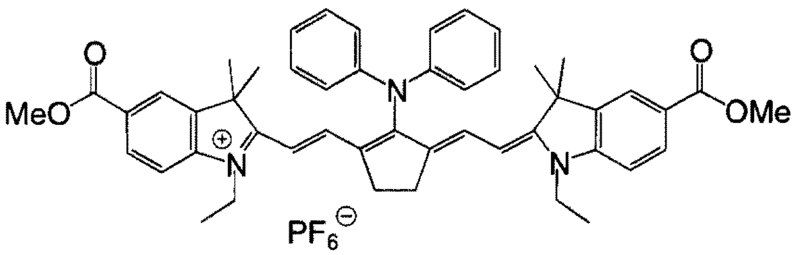

(IR-10)

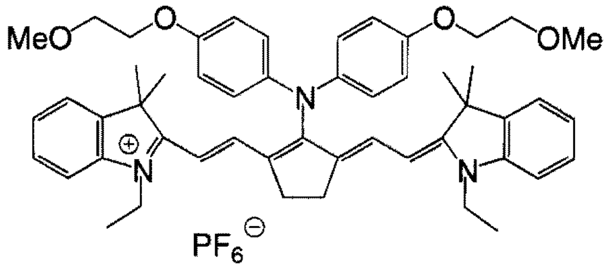

(IR-11)

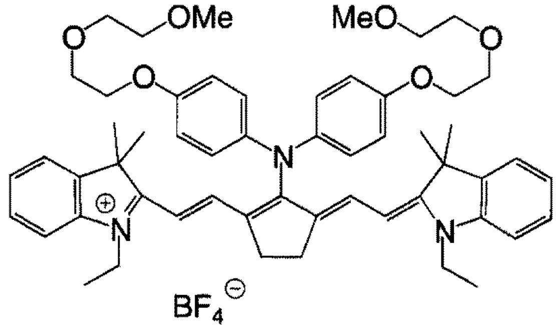

(IR-12)

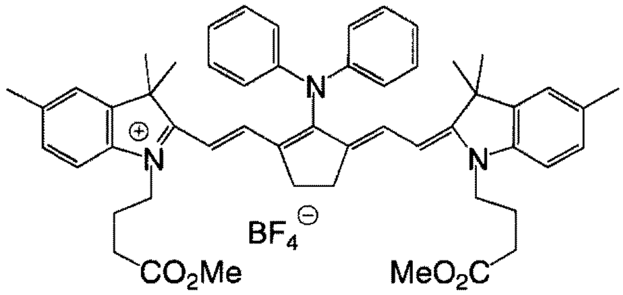

(IR-13)

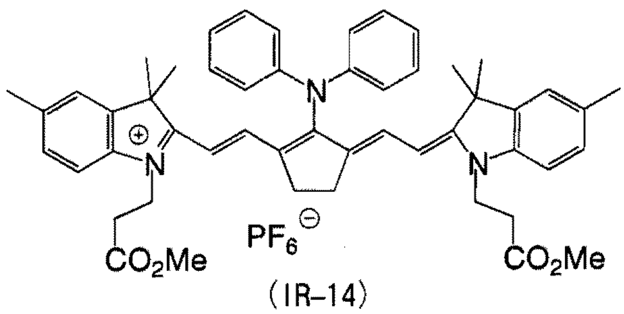

(IR-14)

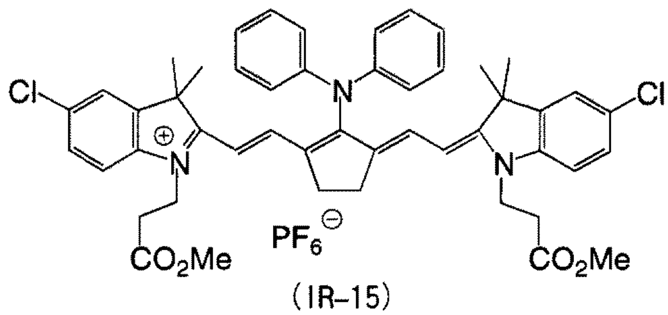

(IR-15)

]

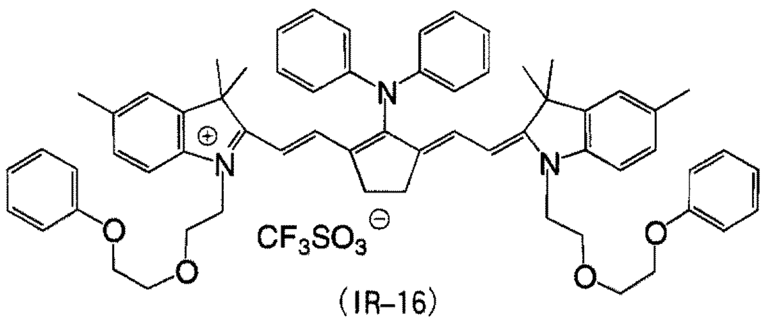

(IR-16)

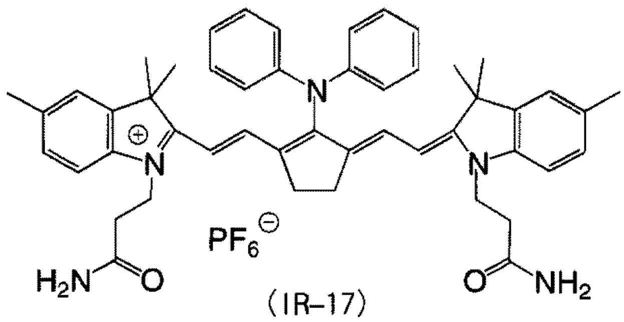

(IR-17)

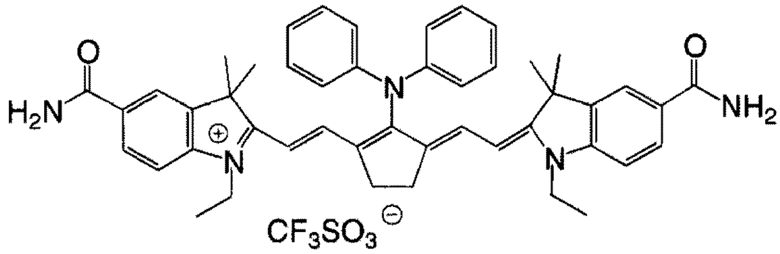

(IR-18)

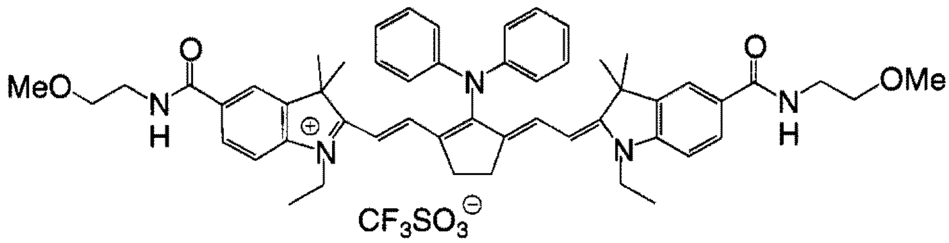

(IR-19)

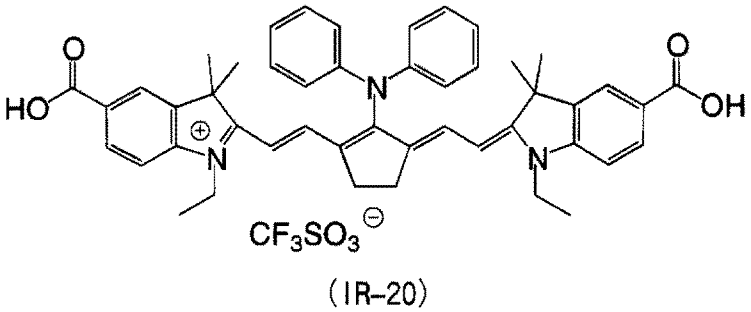

(IR-20)

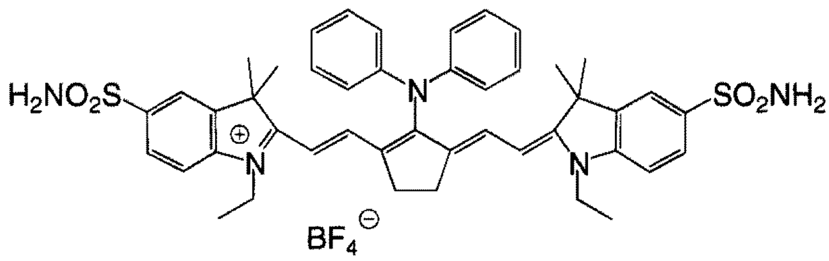

(IR-21)

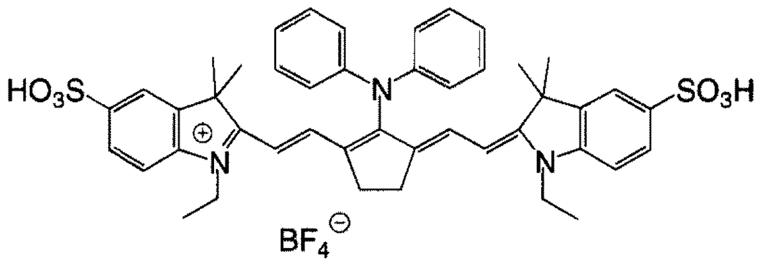

(IR-22)

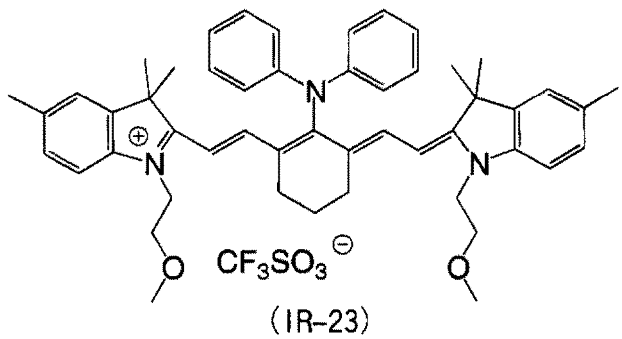

(IR-23)

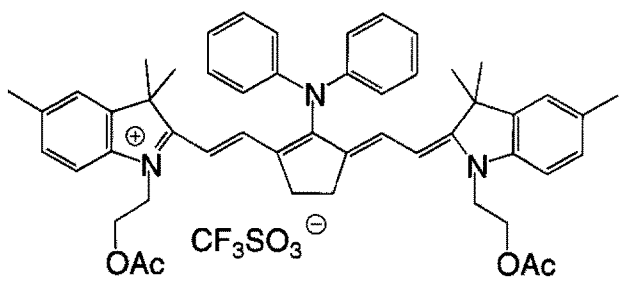

(IR-24)

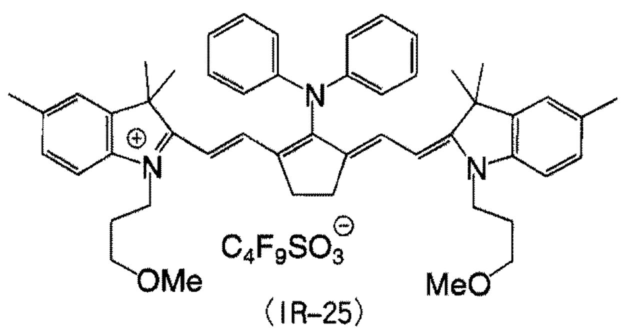

(IR-25)

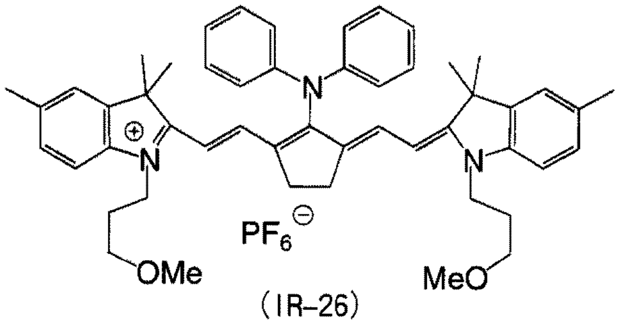

(IR-26)

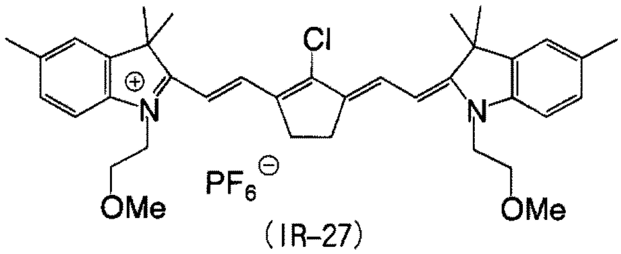

(IR-27)

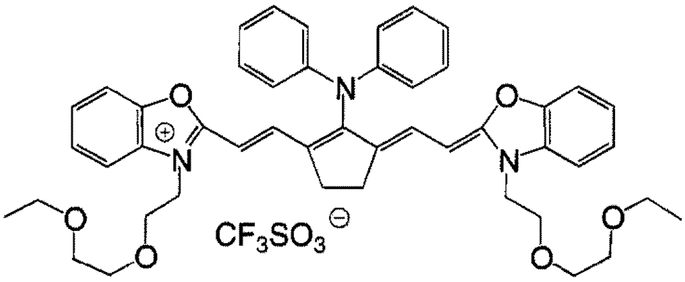

(IR-29)

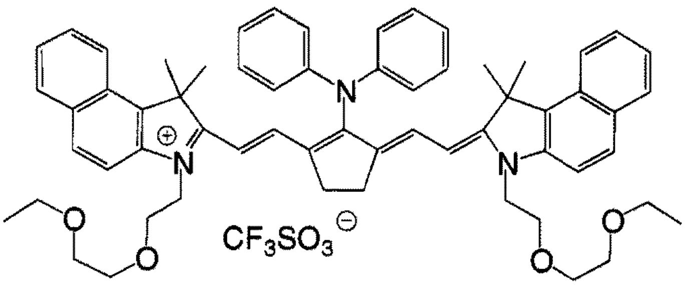

(IR-30)

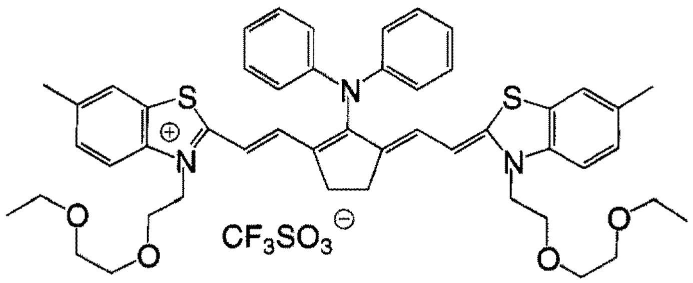

(IR-31)

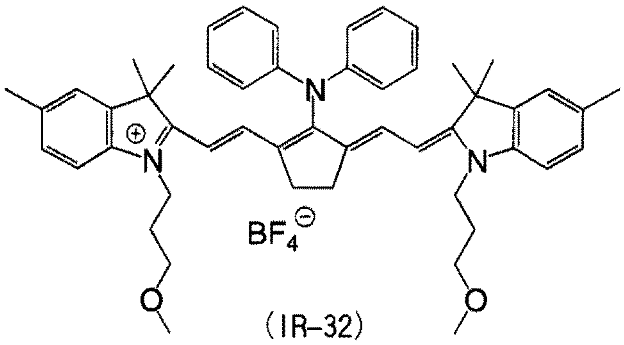

(IR-32)

The infrared absorbing dye that is used in the color developing system A may be used singly or two or more infrared absorbing dyes may be jointly used.

The content of the infrared absorbing dye that is used in the color developing system A is preferably 1 to 100 $mg/m^2$, more preferably 5 to 75 $mg/m^2$, and still more preferably 10 to 60 $mg/m^2$.

In the color developing system A, a color developing aid may be jointly used for the purpose of increasing the color developing efficiency of the infrared absorbing dye. As the color developing aid, an electron-accepting color developing aid that accepts an electron from the infrared absorbing dye that has been excited by heat and/or exposure to an infrared ray, thereby promoting the formation of a color developing body and an electron-attracting color developing aid that donates an electron to the infrared absorbing dye that has been excited by heat and/or exposure to an infrared ray, thereby promoting the formation of a color developing body. Here, in any cases, the color developing aid does not develop a color. The detailed color development mechanism is not clear, but the joint use of the electron-accepting color developing aid and/or the electron-donating color developing aid changes the absorption spectrum of the color developing body, and a result of the hue change being promoted by infrared laser exposure is obtained.

As a specific example of the electron-accepting color developing aid, an onium salt compound is preferably exemplified, and an iodonium salt or a sulfonium salt is particularly preferred.

The iodonium salts are preferably diphenyl iodonium salts, particularly, preferably diphenyl iodonium salts substituted with an electron-donating group, for example, an alkyl group or an alkoxyl group, and preferably asymmetric diphenyl iodonium salts. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=hexafluorophosphate, and bis(4-t-butylphenyl)iodonium=hexafluorophosphate.

The sulfonium salts are preferably triarylsulfonium salts, particularly preferably triarylsulfonium salts substituted with an electron-donating group, for example, triarylsulfonium salts in which at least some of groups on the aromatic ring are substituted with a halogen atom, and still more preferably triarylsulfonium salts in which the total number of substituting halogen atoms on the aromatic ring is four or greater. Specific examples thereof include triphenylsulfonium=hexafluorophosphate, triphenylsulfonium=benzoyl formate, bis(4-chlorophenyl)phenylsulfonium=benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, and tris(2,4-dichlorophenyl)sulfonium=hexafluorophosphate.

As a specific example of the electron-donating color developing aid, a borate compound is preferably exemplified.

As the borate compound, the following compounds are preferably exemplified. In teh following compounds, $X_c^+$ represents a monovalent cation and is preferably an alkali metal ion or a tetraalkyl ammonium ion and more preferably an alkali metal ion or a tetrabutyl ammonium ion. In addition, Bu represents an n-butyl group.

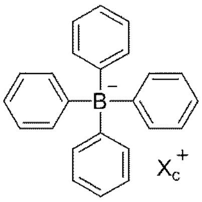

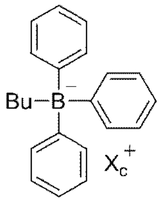

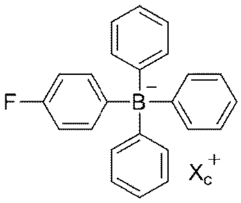

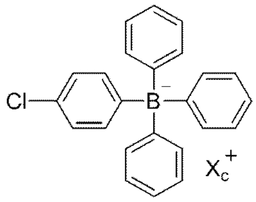

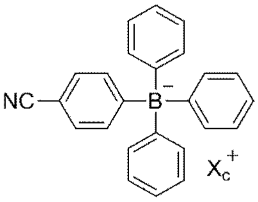
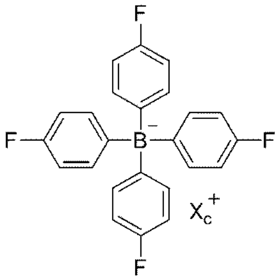
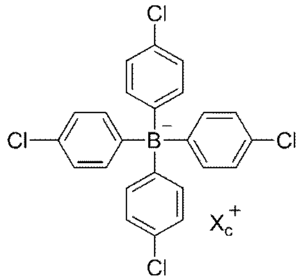

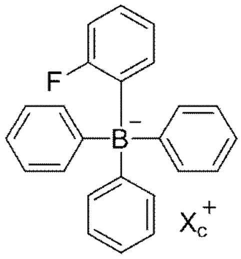
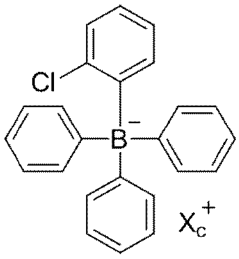
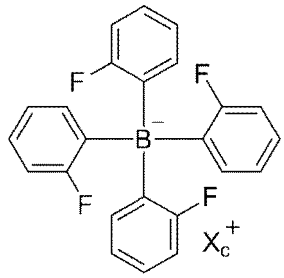

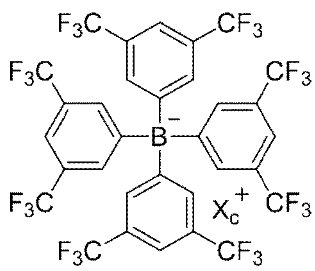

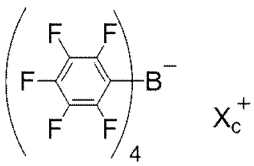
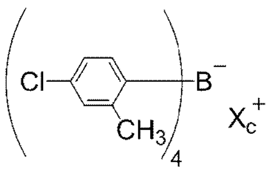
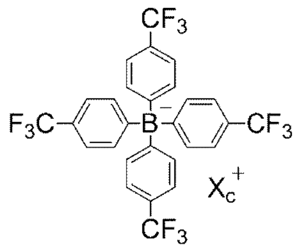

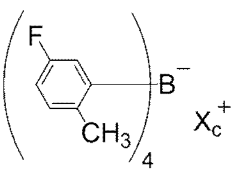
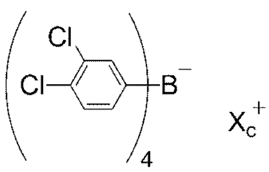
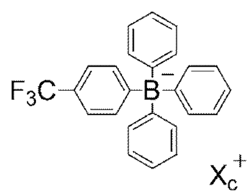

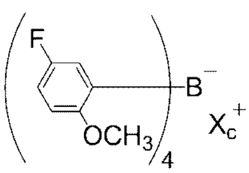
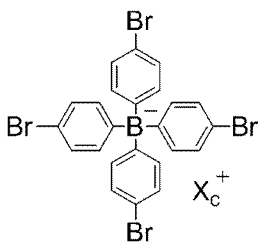

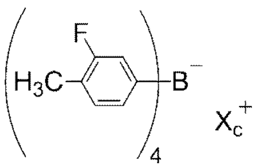
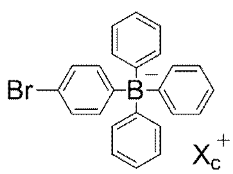
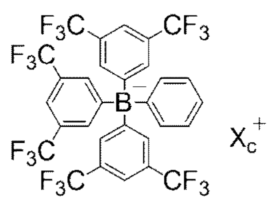

[0106]

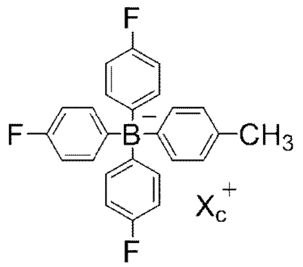

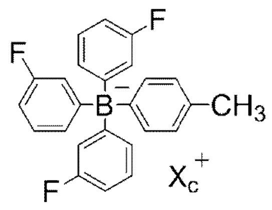

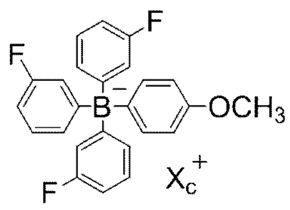

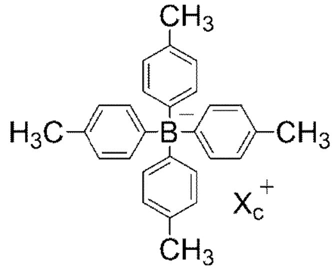

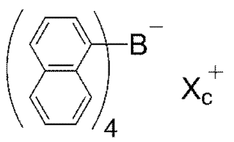

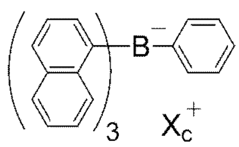

The content of the color developing aid is preferably 0.001 to 0.3 g/$m^2$, more preferably 0.005 to 0.25 g/$m^2$, and particularly preferably 0.01 to 0.2 g/$m^2$.

[Color developing system B]

In the color developing system B, an infrared absorbing dye and a color developing precursor are jointly used.

The infrared absorbing dye that is used in the color developing system B has a function of converting an absorbed infrared ray to heat and a function of being excited by an infrared ray to migrate an electron and/or energy to a color developing precursor or an acid-generating agent described below. The infrared absorbing dye is preferably a dye having the absorption maximum at a wavelength of 760 to 1,200 nm.

As the infrared absorbing dye, cyanine dyes are used and among dyes described in Paragraphs [0059] to [0071] and [0077] to [0086] of JP2008-195018A, cyanine dyes described therein can be used in the present invention.

As an infrared absorbing dye, a cyanine colorant represented by General Formula (a) is used.

General Formula (a)

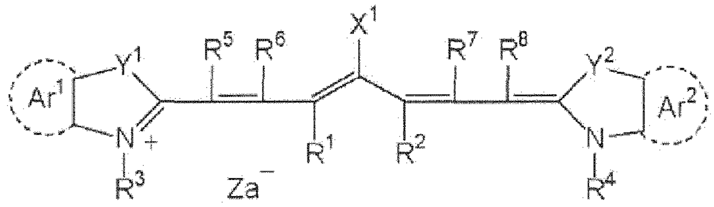

In General Formula (a), $X^1$ represents a hydrogen atom, a halogen atom, $-N(R^9)(R^{10})$, $X^2-L^1$, or a group described below. Here, $R^9$ and $R^{10}$ may be identical to or different from each other and represent an aromatic hydrocarbon group having 6 to 10 carbon atoms, an alkyl group having 1 to 8 carbon atoms, or a hydrogen atom, or $R^9$ and $R^{10}$ may be bonded to each other to form a ring. The aromatic hydrocarbon group having 6 to 10 carbon atoms or the alkyl group having 1 to 8 carbon atoms may have a substituent. Particularly, a phenyl group is preferred. $X^2$ represents an oxygen atom, a nitrogen atom, or a sulfur atom, and $L^1$ represents a hydrocarbon group having 1 to 12 carbon atoms or a hydrocarbon group including a hetero atom and having 1 to 12 carbon atoms. Here, the hetero atom represents N, S, O, a halogen atom, or Se. In the group described below, $Xa^-$ is the same as $Z_a^-$ described below, and $R^a$ represents a hydrogen atom or a substituent selected from an alkyl group, an aryl group, a substituted or unsubstituted amino group, and a halogen atom.

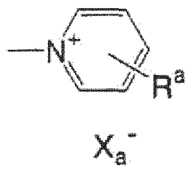

In General Formula (a), $R^1$ and $R^2$ each independently represent a hydrocarbon group having 1 to 12 carbon atoms. From the viewpoint of the storage stability of an image-recording layer coating fluid, $R^1$ and $R^2$ are preferably a hydrocarbon group having 2 or more carbon atoms, and, furthermore, $R^1$ and $R^2$ are particularly preferably bonded to each other to form a five-membered ring or a six-membered ring.

In General Formula (i), $Ar^1$ and $Ar^2$ may be identical to or different from each other and represent an aromatic hydrocarbon group. The aromatic hydrocarbon group may have a substituent. In addition, as a preferred aromatic hydrocarbon group, a benzene ring group and a naphthalene ring group are exemplified. In addition, as a preferred substituent, a hydrocarbon group having 12 or less carbon atoms, a halogen atom, and an alkoxy group having 12 or less carbon atoms are exemplified. $Y^1$ and $Y^2$ may be identical to or different from each other and represent a sulfur atom or a dialkyl methylene group having 12 or less carbon atoms. $R^3$ and $R^4$ may be identical to or different from each other and represent a hydrocarbon group having 20 or less carbon atoms. The hydrocarbon group having 20 or less carbon atoms may have a substituent. As a preferred substituent, an alkoxy group having 12 or less carbon atoms, a carboxyl group, and a sulfo group are exemplified. $R^5$, $R^6$, $R^7$, and $R^8$ may be identical to or different from one another and represent a hydrogen atom or a hydrocarbon group having 12 or less carbon atoms. From the viewpoint of the easy procurement of a raw material, a hydrogen atom is preferred. In addition, $Z_a^-$ represents a counter anion. Here, in case the cyanine colorant represented by General Formula (a) has an anionic substituent in the structure and neutralization of a charge is not necessary, $Z_a^-$ is not required. From the viewpoint of the storage stability of the image-recording layer coating fluid, a preferred $Z_a^-$ is a halogen ion, a perchlorate ion, a tetrafluoroborate ion, a hexafluorophosphate ion, or a sulfonic acid ion, and a perchlorate ion, a hexafluorophosphate ion, or an aryl sulfonate ion are particularly preferred.

As specific examples of the cyanine colorant represented by General Formula (a), cyanine colorants described in Paragraphs [0017] to [0019] of JP2001-133969A, Paragraphs [0012] to [0021] of JP2002-023360A, and Paragraphs [0012] to [0037] of JP2002-040638A can be exemplified.

As the infrared absorbing dye in the color developing system B, the infrared absorbing dye described in the section of the color developing system A can also be used.

The infrared absorbing dye that is used in the color developing system B may be used singly or two or more infrared absorbing dyes may be jointly used.

The content of the infrared absorbing dye that is used in the color developing system B is preferably 1 to 100 $mg/m^2$, more preferably 5 to 75 $mg/m^2$, and still more preferably 10 to 60 $mg/m^2$.

As the color developing precursor that is used in the color developing system B, an acid color developer and a thermal color developer are exemplified. In a case in which the acid color developer is used, the joint use of an acid-generating agent capable of discharging an acid by the migration of an electron and/or energy from the infrared absorbing dye causes the color developing precursor to develop a color by the action of the generated acid. In a case in which the thermal color developer is used, the infrared absorbing dye acts as a photothermal agent, whereby the color developing precursor develops a color by the generated heat.

As the acid color developer that is used as the color developing precursor in the color developing system B, any compound can be preferably used as long as the compound develops a color (changes from colorless to colored) by the action of an acid. Examples of the above-described compound include a triarylmethane compound, a bisphenylmethane compound, a spiropyran compound, and a compound described in JP2001-277730A. Amon these, a triarylmethane compound, a xanthene compound, a fluorane compound, a spiropyran compound, and a compound described in JP2001-277730A are particularly preferred. Specific examples of the preferred acid color developer will be illustrated below.

B-1

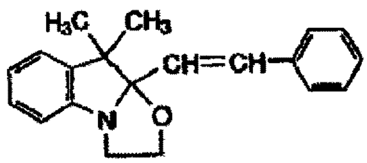

B-2

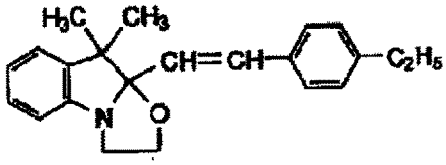

B-3

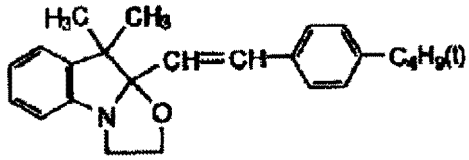

B-4

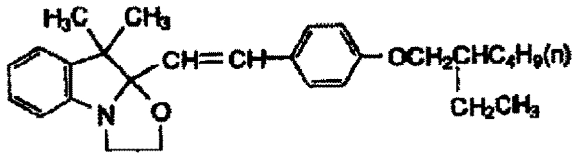

B-5

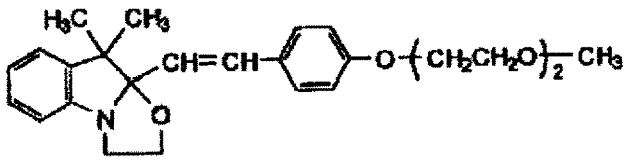

B-6

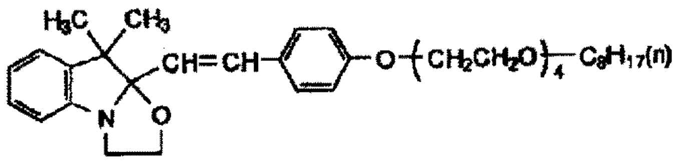

B-7

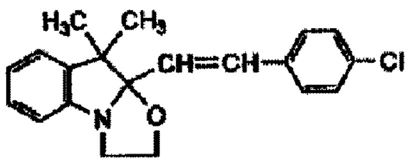

B-8

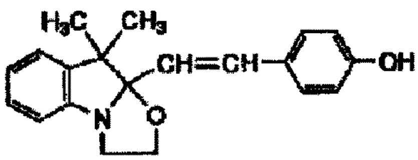

B-9

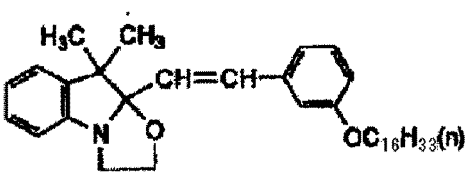

B-10

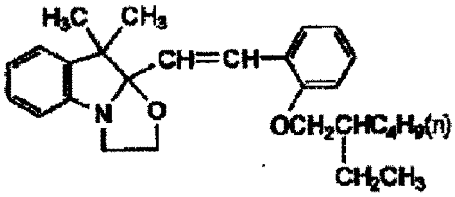

B-11

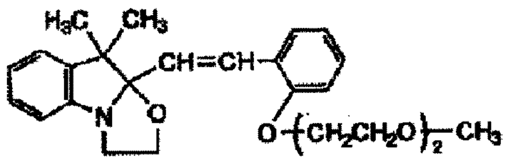

B-12

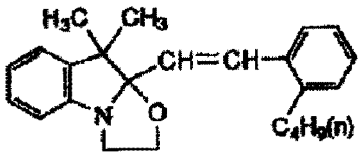

B-53

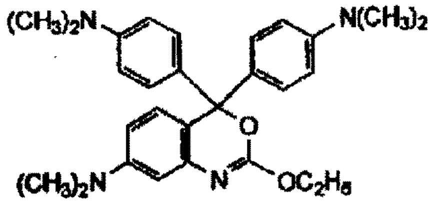

B-54

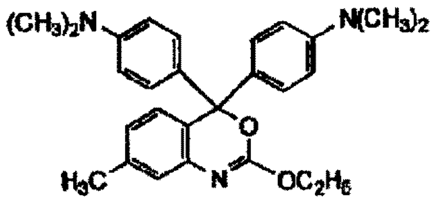

B-55

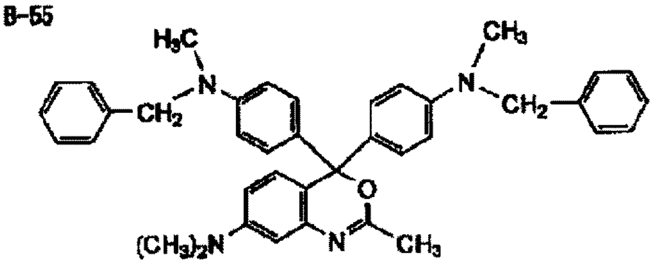

B-56

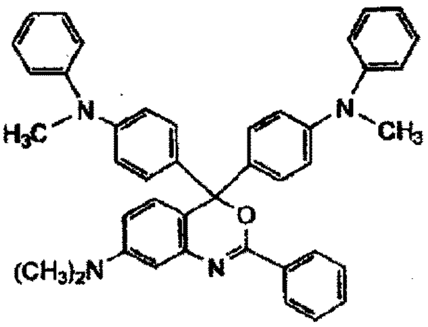

B-57

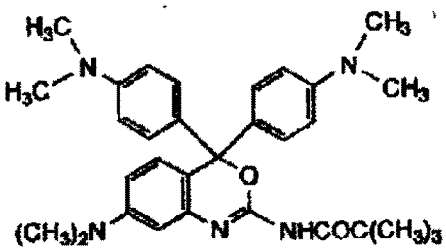

B-58

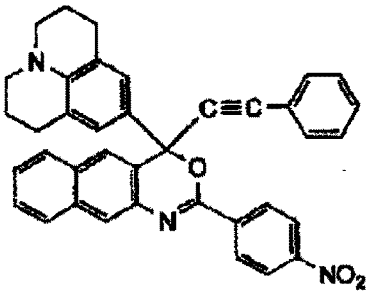

B-59

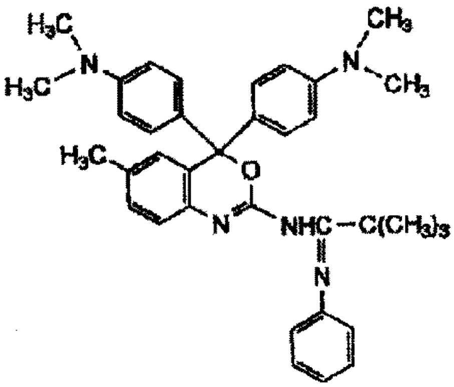

B-60

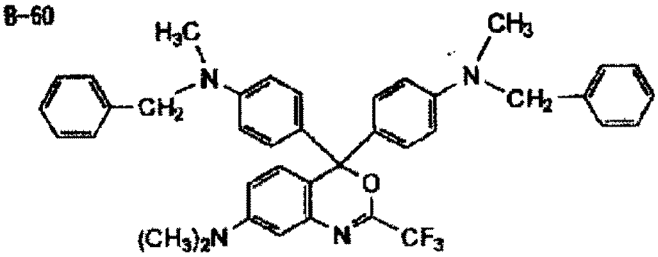

B-109

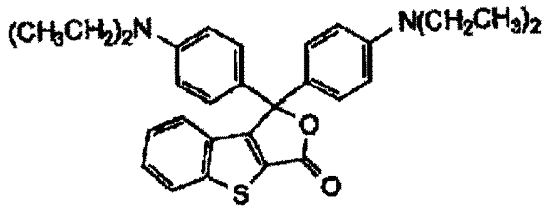

B-110

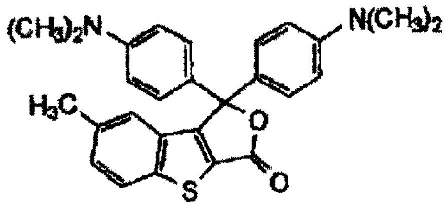

B-111

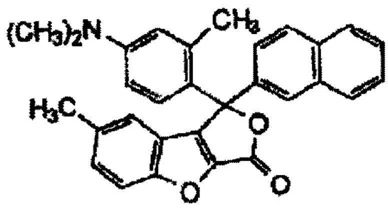

B-112

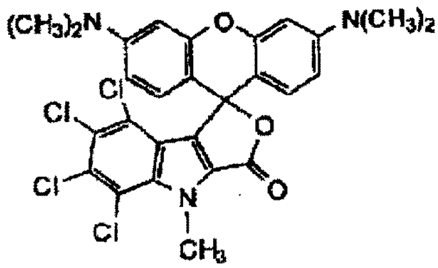

B-113

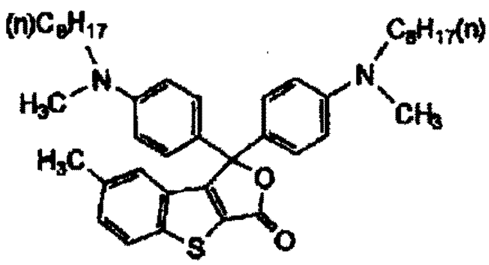

B-114

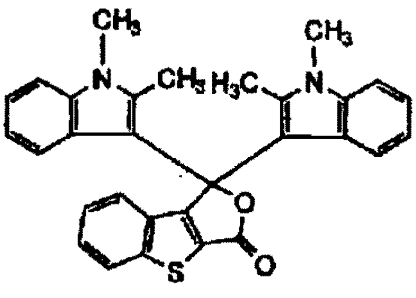

B-115

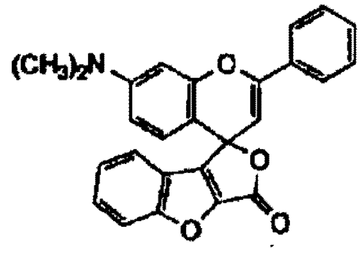

B-116

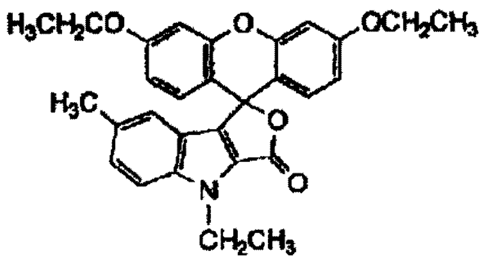

B-117

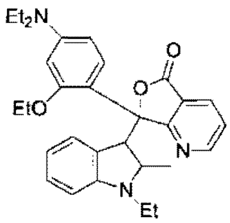

As the thermal color developer that is used as the color developing precursor in the color developing system B, any compound can be preferably used as long as the compound develops a color (changes from colorless to colored) by the action of heat. Examples of the above-described dye include a spiropyran compound, a condensed aromatic ring-substituted ethylene derivative such as an anthrone compound, a polythiophene derivative, a liquid crystal such as a cholesteric liquid crystal, METAMOCOLOR (registered trademark, manufactured by The Pilot Ink Company, Limited) which is a thermochromic material based on an electron trading mechanism by thermal equilibrium in a polar compound of an electron-donating body and an electron-accepting body, and the like. Specific examples of the preferred thermal color developer will be illustrated below.

Spiropyrans

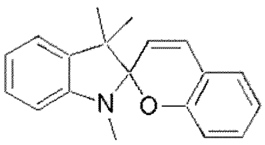
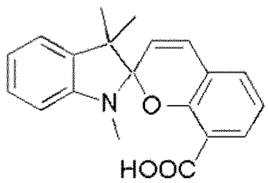
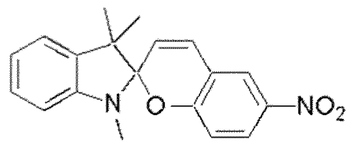
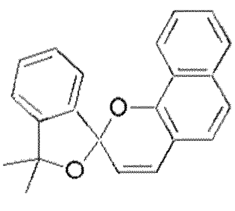
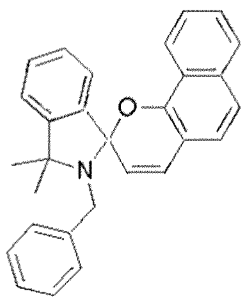
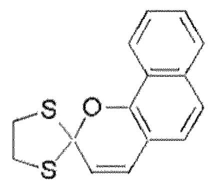

Spirooxazines

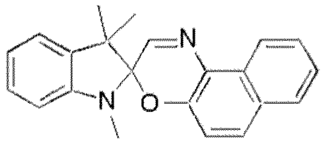

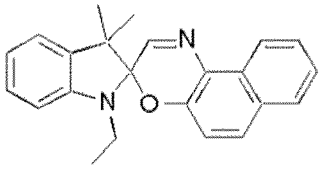

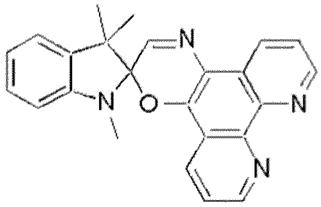

Salicyl Schiff base

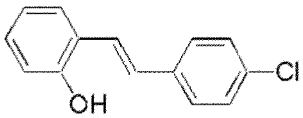

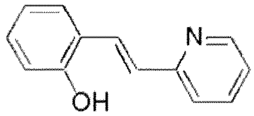

Bianthrones

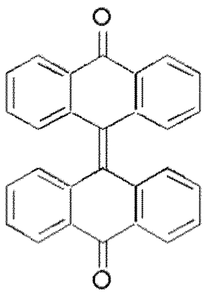

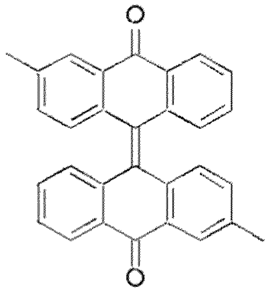

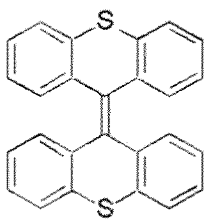

Polythiophenes

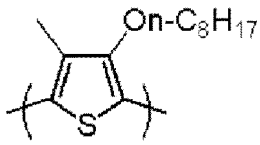

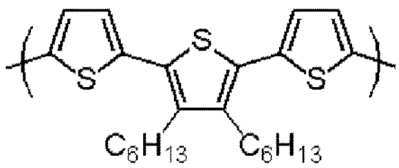

Diazananthracenophanes

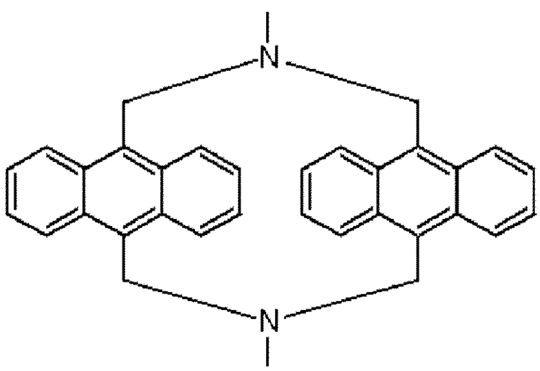

Polyacetylenes

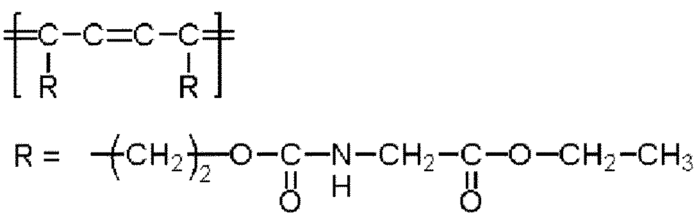

The content of the color developing precursor is preferably 0.001 to 0.3 $g/m^2$, more preferably 0.005 to 0.25 $g/m^2$, and particularly preferably 0.01 to 0.2 $g/m^2$.

In the color developing system B, the acid-generating agent that is jointly used in the case of using the acid color developer as the color developing precursor is a compound that generates an acid by the migration of an electron and/or energy from the photoexcited infrared absorbing dye. The generated acid reacts with the acid color developer, thereby developing a color. The acid being generated is preferably a strong acid such as sulfonic acid, hydrochloric acid, hexafluorophosphoric acid, or tetrafluoroboric acid from the viewpoint of a color developing effect.

As the acid-generating agent, an onium salt such as an iodonium salt, a sulfonium salt, a phosphonium salt, a diazonium salt, or an azinium salt is exemplified. Specifically, compounds described in the specification of US4,708,925A, JP1995-020629A (JP-H07-020629A), and JP2008-195018A can be exemplified. In addition, benzyl sulfonates described in the specification of US5,135,838A or US5,200,544A are also preferred. Furthermore, active sulfonic acid esters described in each of JP1990-100054A (JP-H02-100054A), JP1990-100055A (JP-H02-100055A), and JP1997-197671A (JP-H09-197671A), imide esters such as a sulfonic acid ester of an N-hydroxy imide compound described in JP2008-001740A, or disulfone compounds described in JP1986-166544A (JP-S61-166544A), JP2003-328465A, and the like are also preferred. In addition, oxime ester compounds described in J. C. S. Perkin II (1979) 1653 to 1660), J. C. S. Perkin II (1979) 156 to 162, Journal of Photopolymer Science and Technology (1995) 202 to 232, JP2000-066385A, JP2000-080068A, and JP2008-195018A are also preferred. Additionally, haloalkyl-substituted s-triazine compounds described in JP1995-271029A (JP-H07-271029A) are also preferred.

As the acid-generating agent, an iodonium salt, a sulfonium salt, and an azinium salt are particularly preferred.

Regarding the iodonium salt and the sulfonium salt, the description of the iodonium salt and the sulfonium salt in the above-described section of the electron-accepting color developing aid can be employed.

Examples of the azinium salt include 1-cyclohexylmethyloxypyridinium=hexafluorophosphate, 1-cyclohexyloxy-4-phenylpyridinium=hexafluorophosphate, 1-ethoxy-4-phenylpyridinium=hexafluorophosphate, 1-(2-ethylhexyloxy)-4-phenylpyridinium=hexafluorophosphate, 4-chloro-1 -cyclohexylmethyloxypyridinium=hexafluorophosphate, 1-ethoxy-4-cyanopyridinium=hexafluorophosphate, 3,4-dichloro-1-(2-ethylhexyloxy) pyridinium=hexafluorophosphate, 1-benzyloxy-4-phenylpyridinium=hexafluorophosphate, 1-phenethyloxy-4-phenylpyridinium=hexafluorophosphate, 1-(2-ethylhexyloxy)-4-phenylpyridinium=p-toluenesulfonate, 1-(2-ethylhexyloxy)-4-phenylpyridinium=perfluorobutanesulfonate, 1-(2-ethylhexyloxy)-4-phenylpyridinium=bromide, and 1-(2-ethylhexyloxy)-4-phenylpyridinium=tetrafluoroborate.

The content of the acid-generating agent is preferably 0.001 to 0.3 $g/m^2$, more preferably 0.005 to 0.25 $g/m^2$, and particularly preferably 0.01 to 0.2 $g/m^2$.

[(2) Thermoplastic polymer particle]

The thermoplastic polymer particle included in the image-recording layer of the lithographic printing plate precursor of the embodiment of the invention (hereinafter, also referred to as the thermoplastic fine particle polymer) preferably has a glass transition temperature (Tg) of 60°C to 250°C. Tg of the thermoplastic fine particle polymer is more preferably 70°C to 140°C and still more preferably 80°C to 120°C.

As the thermoplastic fine particle polymer having Tg of 60°C or higher, for example, thermoplastic fine particle polymers described in Research Disclosure No. 33303 (January, 1992), JP1997-123387A (JP-H09-123387A), JP1997-131850A (JP-H09-131850A), JP1997-171249A (JP-H09-171249A), JP1997-171250A (JP-H09-171250A), EP931647A, and the like can be exemplified as preferred thermoplastic fine particle polymers.

Specifically, homopolymers or copolymers constituted of a monomer such as ethylene, styrene, vinyl chloride, methyl acrylate, ethyl acrylate, methyl methacrylate, ethyl methacrylate, vinylidene chloride, acrylonitrile, or vinyl carbazole, mixtures thereof, and the like can be exemplified. As a preferred thermoplastic fine particle polymer, polystyrene, polymethyl methacrylate, and the like are exemplified.

The average particle diameter of the thermoplastic fine particle polymer is preferably 0.005 to 2.0 μm. In a case in which the average particle diameter is too large, there is a case in which the resolution becomes poor, and, in a case

in which the average particle diameter is too small, there is a case in which the temporal stability becomes poor. This value is also applied as an average particle diameter in a case in which two or more thermoplastic fine particle polymers are mixed together. The average particle diameter is more preferably 0.01 to 1.5 μm and particularly preferably 0.05 to 1.0 μm. The polydispersibility in a case in which two or more thermoplastic fine particle polymers are mixed together is preferably 0.2 or more. The average particle diameter and the polydispersibility are computed by laser light scattering.

Two or more thermoplastic fine particle polymers may also be used in mixture. Specific examples thereof include the use of at least two thermoplastic fine particle polymers having different particle sizes and the use of at least two thermoplastic fine particle polymers having different Tg. In a case in which two or thermoplastic fine particle polymers are used in mixture, the membrane curing property of the image area further improves, and the printing resistance in the case of processing the lithographic printing plate precursor into a lithographic printing plate further improves.

For example, in a case in which the thermoplastic fine particle polymers having the same particle size are used, a certain number of pores are present between the thermoplastic fine particle polymers, and there is a case in which the curing property of the membrane fails to become a desired property even in a case in which the thermoplastic fine particle polymer is melted and solidified by image exposure. In contrast, in a case in which the thermoplastic fine particle polymers having different particle sizes are used, it is possible to decrease the void volume between the thermoplastic fine particle polymers, and consequently, the membrane curing property of the image area after image exposure can be improved.

In addition, in a case in which the thermoplastic fine particle polymers having the same Tg are used, when the temperature of the image-recording layer does not sufficiently increase by image exposure, there is a case in which the thermoplastic fine particle polymer are not sufficiently melted and solidified and the curing property of the membrane fails to become a desired property. In contrast, in a case in which the thermoplastic fine particle polymers having different Tg's are used, even when the temperature of the image-recording layer does not sufficiently increase by image exposure, it is possible to improve the membrane curing property of the image area.

In a case in which two or more thermoplastic fine particle polymers having different Tg's are used in mixture, Tg of at least one of the thermoplastic fine particle polymers is preferably 60°C. At this time, the difference in Tg is preferably 10°C or more and more preferably 20°C or more. In addition, the content of the thermoplastic fine particle polymer having Tg of 60°C or higher is preferably 70% by mass of all of the thermoplastic fine particle polymers from the viewpoint of the on-machine developability and the printing resistance.

The thermoplastic fine particle polymer may have a crosslinking group. In a case in which the thermoplastic fine particle polymer having a crosslinking group is used, the crosslinking group thermally reacts due to heat generated in an image exposed portion, crosslink is formed between the polymers, the membrane hardness of the image area increases, and the printing resistance becomes superior. The crosslinking group may be any functional group that causes any reaction as long as a chemical bond is formed, and examples thereof include an ethylenic unsaturated group that causes a polymerization reaction (for example, an acryloyl group, a methacryloyl group, a vinyl group, an allyl group, or the like), an isocyanate group that causes an addition reaction or a blocked body thereof and a group having an active hydrogen atom which is a reaction partner of the isocyanate group (for example, an amino group, a hydroxy group, a carboxyl group, or the like), an epoxy group that, similarly, causes an addition reaction or an amino group that is a reaction partner of the epoxy group, a carboxyl group or a hydroxy group, a carboxyl group that causes a condensation reaction and a hydroxy group or an amino group, an acid anhydride that causes a ring-opening addition reaction and an amino group or a hydroxy group, or the like.

As the thermoplastic fine particle polymer having a crosslinking group, specifically, thermoplastic fine particle polymers having a crosslinking group such as an acryloyl group, a methacryloyl group, a vinyl group, an allyl group, an epoxy group, an amino group, a hydroxy group, a carboxyl group, an isocyanate group, an acid anhydride, and a group that protects the above-described groups can be exemplified. These crosslinking groups may be introduced to the polymer during the polymerization of the fine particle polymer or may be introduced using a polymer reaction after the polymerization of the fine particle polymer.

In the case of introducing the crosslinking group during the polymerization of the fine particle polymer, the emulsification polymerization or the suspension polymerization of a monomer having the crosslinking group is preferred, and specific examples of the monomer having the crosslinking group include allyl methacrylate, allyl acrylate, vinyl methacrylate, vinyl acrylate, glycidyl methacrylate, glycidyl acrylate, 2-isocyanate ethyl methacrylate or blocked isocyanate by an alcohol thereof, 2-isocyanate ethyl acrylate or blocked isocyanate by an alcohol thereof, 2-aminoethyl methacrylate, 2-aminoethyl acrylate, 2-hydroxyethyl methacrylate, 2-hydroxyethyl acrylate, acrylic acid, methacrylic acid, maleic anhydride, difunctional acrylate, difunctional methacrylate, and the like.

As the polymer reaction that is used in a case in which the crosslinking group is introduced after the polymerization of the fine particle polymer, for example, a polymer reaction described in WO96/34316 can be exemplified.

The thermoplastic fine particle polymers may be reacted with each other through the crosslinking group or may react with a polymer compound or a low-molecular-weight compound added to the image-recording layer.

The content of the thermoplastic fine particle polymer is 70% by mass or more of the solid content of the image-recording layer, but is preferably 80% by mass or more and more preferably 90% by mass or ore. The upper limit of the content of the thermoplastic fine particle polymer is preferably 99% by mass.

The image-recording layer is capable of containing a component as described below in addition to the color developing system in which the hue change generated by infrared laser exposure is $\Delta a/\Delta b \geq 0.6$ and the thermoplastic polymer particle.

The image-recording layer is capable of containing a hydrophilic resin. Examples of the hydrophilic resin include resins having a hydrophilic group such as a hydroxy group, a hydroxyethyl group, a hydroxypropyl group, an amino group, an aminoethyl group, an aminopropyl group, a carboxyl group, a carboxylate group, a sulfo group, a sulfonato group, or a phosphoric acid group.

Specific examples of the hydrophilic resin can include gum arabic, casein, gelatin, starch derivatives, carboxymethyl cellulose and sodium salts thereof, cellulose acetate, sodium alginate, vinyl acetate-maleic acid copolymers, styrene-maleic acid copolymers, polyacrylic acids and salts thereof, polymethacrylic acids and salts thereof, homopolymers and copolymers of hydroxyethyl methacrylate, homopolymers and copolymers of hydroxyethyl acrylate, homopolymers and copolymers of hydroxypropyl methacrylate, homopolymers and copolymers of hydroxypropyl acrylate, homopolymers and copolymers of hydroxybutyl methacrylate, homopolymers and copolymers of hydroxybutyl acrylate, polyethylene glycols, hydroxypropylene polymers, polyvinyl alcohols, hydrolyzed polyvinyl acetate having a degree of hydrolysis of at least 60% and preferably at least 80%, polyvinyl formal, polyvinyl butyral, polyvinyl pyrrolidone, homopolymers and copolymers of acrylamide, homopolymers and copolymers of methacrylamide, homopolymers and copolymers of N-methylol acrylamide, and the like.

The molecular weight of the hydrophilic resin is preferably 2,000 or more. In a case in which the molecular weight is less than 2,000, a sufficient membrane hardness or printing resistance cannot be obtained, which is not preferable.

The content of the hydrophilic resin is 0.5 to 30% by mass and more preferably 0.7 to 20% by mass of the solid content of the image-recording layer.

To the image-recording layer, an inorganic fine particle may be added. As the inorganic fine particle, silica, alumina, magnesium oxide, titanium oxide, magnesium carbonate, calcium alginate, mixtures thereof, and the like are exemplified as preferred examples. The inorganic fine particle is useful for the strengthening of membranes, transportation by surface roughening, the prevention of damage during a process or the like, and the prevention of collapse during shipping.

The average particle diameter of the inorganic fine particles is preferably 5 nm to 10 μm and more preferably 10 nm to 1 μm. In this range, the inorganic fine particle is stably dispersed together with the thermoplastic fine particle polymer, the film hardness of the image-recording layer is sufficiently maintained, and a non-image area having an excellent hydrophilicity in which printing contamination does not easily occur can be formed.

The inorganic fine particle can be easily procured from a commercially available product such as a colloidal silica dispersion.

The content of the inorganic fine particle is preferably 1.0 to 70% by mass and more preferably 5.0 to 50% by mass of the solid content of the image-recording layer.

To the image-recording layer, a plasticizer for imparting the flexibility and the like of a coated film can be added if necessary. Examples of the plasticizer include polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, and the like.

In a case in which a fine particle polymer having a thermally reactive functional group (crosslinking group) is used in the image-recording layer, it is possible to add a compound that initiates or accelerates the reaction of the thermally reactive functional group (crosslinking group) if necessary. As the compound that initiates or accelerates the reaction of the thermally reactive functional group, compounds that generate a radical or a cation by heat can be exemplified. Examples thereof include a rofin dimer, a trihalomethyl compound, a peroxide, an azo compound, a diazonium salt, an onium salt including a diphenyliodonium salt or the like, acylphosphine, imidosulfonate, and the like. The amount of the above-described compound added is preferably 0.1% to 50% by mass, more preferably 0.5% to 30% by mass, and particularly preferably 0.8% to 20% by mass of the solid content of the image-recording layer. In this range, a favorable reaction initiation or acceleration effect can be obtained without impairing on-machine developability.

The image-recording layer may contain an anionic surfactant for the purpose of ensuring the uniformity of the coating of the image-recording layer.

The anionic surfactant is not particularly limited as long as the above-described purpose is achieved. Particularly, alkyl benzene sulfonic acid or a salt thereof, alkyl naphthalene sulfonic acid or a salt thereof, (di)alkyl diphenyl ether (di)sulfonic acid or a salt thereof, and alkyl sulfate ester salt are preferred.

The amount of the anionic surfactant added is preferably 0.1% to 30% by mass, more preferably 0.1% to 20% by mass of the solid content of the image-recording layer, and, from the viewpoint of satisfying both the strength of the image-recording layer and the developability of the non-image area, particularly preferably 0.1% to 10% by mass.

[Formation of image-recording layer]

The image-recording layer is formed by dissolving or dispersing the necessary respective components described above in an appropriate solvent to prepare a coating fluid and applying the coating fluid to a support. As the solvent, water or a solvent mixture of water and an organic solvent is used, and the use of a mixture of water and an organic solvent is preferred from the viewpoint of improving the surface state after the application. The amount of the organic solvent varies depending on the kind of the organic solvent and thus, generally, cannot be specified; however, is, generally, preferably 5% to 50% by volume of the solvent mixture. Here, the amount of the organic solvent needs to be adjusted so as to prevent the agglomeration of the thermoplastic fine particle polymer. The concentration of the solid content of the coating fluid for the image-recording layer is preferably 1% to 50% by mass.

The organic solvent that is used as the solvent of the coating fluid is preferably an organic solvent that is soluble in water. Specifically, alcohol solvents such as methanol, ethanol, propanol, isopropanol, and 1-methoxy-2-propanol, ketone solvents such as acetone and methyl ethyl ketone, glycol ether solvents such as ethylene glycol dimethyl ether, γ-butyrolactone, N,N-dimethylformamide, N,N-dimethylacetamide, tetrahydrofuran, dimethylsulfoxide, and the like are exemplified. Particularly, an organic solvent which has a boiling point of 120°C or lower and a solubility in water (the amount of the organic solvent dissolved in 100 g of water) of 10 g or more is preferred, and an organic solvent having a solubility of 20 g or more is more preferred.

As a method for applying the coating fluid for the image-recording layer, a variety of methods can be used. Examples thereof include bar coater coating, rotary coating, spray coating, curtain coating, dip coating, air knife coating, blade coating, roll coating, and the like. The amount (solid content) of the image-recording layer applied onto the support which is obtained after the application and drying varies depending on the usage; however, is, generally, preferably 0.3 to 5.0 $g/m^2$ and more preferably 0.3 to 3.0 $g/m^2$.

[Support]

The support that is used in the lithographic printing plate precursor of the embodiment of the invention is a substrate having a hydrophilic surface or a substrate imparted with a hydrophilic surface by the coating of a hydrophilic layer or the like. Specifically, paper, plastic (for example, polyethylene, polypropylene, polystyrene, or the like)-laminated paper, a metal plate (for example, aluminum, zinc, copper, or the like), a plastic film (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, or the like), the above-described metal-laminated or deposited paper or plastic film, and a substrate obtained by coating the above-described substrate with a hydrophilic layer are exemplified. As a preferred support, an aluminum plate and a polyester film coated with a hydrophilic layer are exemplified.

The aluminum plate refers to a pure aluminum plate or an alloy plate including aluminum as a main component and a small amount of a foreign element, and, furthermore, the aluminum plate may be a plate obtained by laminating plastic on a thin plate of aluminum or an aluminum alloy. The foreign element that is included in the aluminum alloy is silicon, iron, manganese, copper, magnesium, chromium, zinc, bismuth, nickel, titanium, or the like. The content of the foreign element in the alloy is 10% or less. In addition, the aluminum plate may be an aluminum plate from an aluminum ingot for which a DC casting method is used or an aluminum plate from an ingot by a continuous casting method. To the aluminum plate, a well-known and ordinarily-used material of the related art, for example, JIS A 1050, JIS A 1100, JIS A 3103, JIS A 3005, or the like can also be appropriately used.

The thickness of the substrate is generally 0.05 to 0.6 mm, preferably 0.1 to 0.4 mm, and particularly preferably 0.15 to 0.3 mm.

Generally, the aluminum plate for the lithographic printing plate precursor is manufactured by being subjected to a defatting step of removing a rolling oil attached to an aluminum plate, a desmut treatment step of dissolving and removing smuts on the surface of the aluminum plate, and a roughening treatment step of roughening the surface of the aluminum plate.

Specifically, on the aluminum plate, a dissolution treatment is carried out using an alkali aqueous solution such as caustic soda in order to remove strong contamination or a natural oxide film, and a neutralization treatment of immersing the aluminum plate in an acid such as phosphoric acid, nitric acid, sulfuric acid, hydrochloric acid, or chromic acid or an acid mixture thereof is carried out in order to neutralize a residual alkali component after the treatment. If necessary, a solvent defatting treatment using trichloroethylene, a thinner, or the like or an emulsion defatting treatment using an emulsion such as kerosene or triethanol may be carried out in order to remove fat and oil, rust, dust, or the like on the surface of the aluminum plate.

In a case in which an electrochemical roughening treatment described below is carried out subsequent to the dissolution treatment using an alkali aqueous solution and the neutralization treatment using an acid, the kind and composition of the acid that is used in the neutralization treatment are preferably matched to the kind and composition

of an acid that is used in the electrochemical roughening treatment.

The roughening treatment of the surface of the aluminum plate is carried out using a variety of methods. Examples thereof include a method in which the surface is mechanically roughened, a method in which the surface is electrochemically dissolved and roughened, a method in which the surface is chemically and selectively dissolved, and a method obtained by combining the above-described methods.

As the mechanical roughening method, it is possible to use a well-known method such as a ball polishing method, a brush polishing method, a blast polishing method, or a buffing method. As the chemical roughening method, a method in which the aluminum plate is immersed in a saturated aqueous solution of an aluminum salt of a mineral acid, which is described in JP1979-031187A (JP-S54-031187A), is suitable. As the electrochemical roughening method, there is a method in which the surface is roughened by an alternating current or a direct current in an electrolytic solution including an acid such as hydrochloric acid or nitric acid. In addition, an electrochemical roughening method using an acid mixture disclosed in JP1979-063902A (JP-S54-063902A) can also be used.

The roughening is preferably carried out so that the central line average roughness (Ra) of the surface of the aluminum plate reaches 0.2 to 1.0 μm.

On the roughened aluminum plate, if necessary, an alkali etching treatment is carried out using an aqueous solution of potassium hydroxide, sodium hydroxide, or the like, and, furthermore, a neutralization treatment is carried out.

In the present invention, it is preferable to provide a hydrophilic film to the aluminum plate on which the above-described roughening treatment and, if necessary, other treatments have been carried out. Particularly, a support provided with a hydrophilic film having a density of 1,000 to 3,200 kg/m$^3$ is preferred since the membrane hardness and the contamination resistance during printing are favorable, the diffusion of heat generated in the image-recording layer to the support is prevented, and the adiabaticity is favorable.

The density can be measured by, for example, computation using the mass and the cross section of the hydrophilic layer obtained by a Mason method (the hydrophilic film is dissolved using a chromium acid/phosphorus acid-mixed liquid and the mass of the hydrophilic film is obtained), the film thickness of the hydrophilic film obtained by observation using a scanning electron microscope (SEM), and the following expression.

$$\text{Density (kg/m}^3\text{)=(mass of hydrophilic film per unit area)/film thickness}$$

In a case in which the density of the hydrophilic film is less than 1,000 kg/m$^3$, the membrane hardness becomes low, there is a possibility that the image-forming property, the printing resistance, and the like may be adversely affected, and there is a possibility that the contamination resistance during printing may deteriorate. In a case in which the density of the hydrophilic film exceeds 3,200 kg/m$^3$, a sufficient adiabaticity cannot be obtained, and there is a possibility that a sensitivity improvement effect may degrade.

A method for providing the hydrophilic film is not particularly limited, and it is possible to appropriately use an anodization method, a deposition method, a CVD method, a sol-gel method, a sputtering method, an ion plating method, a diffusion method, or the like. In addition, it is also possible to use a method in which a solution obtained by mixing a hollow particle into a hydrophilic resin or a sol-gel liquid is applied.

Particularly, it is particularly preferable to use a treatment in which an oxide film is produced using an anodization method, that is, the anodization treatment. The anodization treatment can be carried out using a method that has been carried out in the related art in this field. Specifically, in a case in which an alternating current or a direct current is caused to flow through the aluminum plate in an aqueous solution or a non-aqueous solution of sulfuric acid, phosphoric acid, chromic acid, oxalic acid, sulfamic acid, or benzenesulfonic acid or a combination of two or more of the above-described acids, it is possible to form an anodized film which is a hydrophilic film on the surface of the aluminum plate.

The conditions for the anodization treatment vary in a diverse manner depending on the electrolytic solution being used and thus cannot be generally determined; however, generally, it is appropriate to set the concentration of the electrolytic solution to 1% to 80%, the liquid temperature to 5°C to 70°C, the current density to 0.5 to 60 A/dm$^2$, the voltage to 1 to 200 V, and the electrolysis duration to 1 to 1,000 seconds.

Among anodization treatments, a method in which an anodization treatment is carried out in a sulfuric acid electrolytic solution at a high current density, which is described in UK1,412,768A, a method in which an anodization treatment is carried out using phosphoric acid as an electrolysis bath, which is described in US3,511,661A, and the like are preferred. In addition, it is also possible to carry out a multi-stage anodization treatment by carrying out an anodization treatment in sulfuric acid and, furthermore, carry out an anodization treatment in phosphoric acid.

In the present invention, the amount of the anodized film is preferably 1.5 g/m$^2$ or more from the viewpoint of effectively preventing the non-image area from being damaged and contaminated.

The support may be a substrate having an anodized film by being subjected to the above-described roughening treatment; however, for the additional improvement of the adhesiveness to an upper layer, the hydrophilicity, the contamination resistance, the adiabaticity, and the like, if necessary, it is possible to appropriately select and carry out an

enlargement treatment of micropores in the anodized film, a sealing treatment of micropores, a surface hydrophilization treatment in which the aluminum plate is immersed in an aqueous solution containing a hydrophilic compound, and the like which are described in JP2001-253181A or JP2001-322365A.

As the hydrophilic compound preferable for the surface hydrophilization treatment, polyvinylphosphonic acid, a compound having a sulfonic acid group, a saccharide compound, citric acid, an alkali metal silicate, potassium zirconium fluoride, a phosphate/inorganic fluorine compound can be exemplified.

[Undercoat Layer]

The lithographic printing plate precursor of the embodiment of the invention may have an undercoat layer between the support and the image-recording layer if necessary. The undercoat layer strengthens adhesiveness between the support and the image-recording layer in exposed portions and facilitates peeling the support and the image-recording layer in non-exposed portions, and thus the undercoat layer contributes to improving on-machine developability without impairing printing resistance. In addition, in the case of exposure using infrared lasers, the undercoat layer functions as an adiabatic layer and thus has an action of preventing the sensitivity from being degraded due to the diffusion of heat generated by exposure in the support.

As a compound that is used in the undercoat layer, specifically, a silane coupling agent having an ethylenic double bond reactive group that is capable of addition polymerization described in JP1998-282679A (JP-H10-282679A) and a phosphorus compound having an ethylenic double bond reactive group described in JP1990-304441A (JP-H02-304441A) are exemplified. As a preferred compound, a polymer compound having an adsorbent group that can be adsorbed to the surface of the support, a hydrophilic group, and/or a crosslinking group as described in JP2005-125749A and JP2006-188038A is exemplified. As the above-described polymer compound, a copolymer of a monomer having an adsorbent group, a monomer having a hydrophilic group, and a monomer having a crosslinking group is preferred. More specifically, a copolymer of a monomer having an adsorbent group such as a phenolic hydroxy group, a carboxy group, $-PO_3H_2$, $-OPO_3H_2$, $-CONHSO_2-$, $-SO_2NHSO_2-$, or $-COCH_2COCH_3$, a monomer having a hydrophilic group such as a sulfo group, and, furthermore, a monomer having a polymerizable crosslinking group such as a methacrylic group or an allyl group is exemplified. The polymer compound may have a polar substituent of a polymer compound and a crosslinking group introduced by the formation of a salt of a substituent having a counter charge and a compound having an ethylenic unsaturated bond. In addition, a monomer that has not been described above, preferably, a hydrophilic monomer may be further copolymerized.

The content of the unsaturated double bond in the polymer compound for the undercoat layer is preferably in a range of 0.1 to 10.0 mmol and more preferably in a range of 2.0 to 5.5 mmol per gram of the polymer compound.

The mass average molecular weight of the polymer compound for the undercoat layer is preferably 5,000 or higher and more preferably in a range of 10,000 to 300,000.

In addition to the above-described compounds for the undercoat layer, the undercoat layer is capable of containing a chelating agent, a secondary or tertiary amine, a polymerization inhibitor, a compound having an amino group or a functional group having a polymerization-inhibiting function and a group that interacts with the surface of an aluminum support (for example, 1,4-diazabicyclo[2,2,2]octane (DABCO), 2,3,5,6-tetrahydroxy-p-quinone, chloranil, sulfophthalic acid, hydroxyethyl ethylene diamine triacetic acid, dihydroxyethyl ethylenediamine diacetic acid, hydroxyethyl iminodiacetic acid, and the like), and the like in order to prevent contamination over time.

The undercoat layer is formed using well-known coating methods. The coating amount (solid content) of the undercoat layer is preferably in a range of 0.1 to 100 $mg/m^2$ and more preferably in a range of 1 to 30 $mg/m^2$.

[Overcoat layer]

The lithographic printing plate precursor of the embodiment of the invention can be provided with a hydrophilic overcoat layer on the image-recording layer in order to protect the hydrophilic surface of the image-recording layer from contamination by a lipophilic substance during storage, fingerprint mark contamination by the contact with a finger during handling, or the like.

The overcoat layer can be easily removed on a printer and contains a water-soluble resin or a water swellable resin obtained by partially crosslinking a water-soluble resin.

The water-soluble resin is selected from a water-soluble natural polymer and a water-soluble synthetic polymer, the water-soluble resin is used singly or together with a crosslinking agent, and a membrane obtained by applying and drying the water-soluble resin has a capability of forming a film.

Specific examples of the water-soluble resin that is preferably used include, as natural polymers, gum arabic, water-soluble soybean polysaccharides, cellulose derivatives (for example, carboxymethyl cellulose, carboxyethyl cellulose, methyl cellulose, and the like), modified bodies thereof, white dextrin, pullulan, enzymatically decomposed etherified dextrin, and the like, as synthetic polymers, polyvinyl alcohols (polyvinyl acetates having a degree of hydrolysis

of 65% or more), polyacrylic acid, alkali metal salts or amine salts thereof, polyacrylic acid copolymers, alkali metal salts or amine salts thereof, polymethacrylic acid, alkali metal salts or amine salts thereof, vinyl alcohol/acrylic acid copolymers, alkali metal salts or amine salts thereof, polyacrylamide, copolymers thereof, polyhydroxyethyl acrylate, polyvinyl pyrrolidone, copolymers thereof, polyvinyl methyl ether, vinyl methyl ether/maleic anhydride copolymers, poly-2-acrylamido-2-methyl-1-propanesulfonic acid, alkali metal salts or amine salts thereof, poly-2-acrylamido-2-methyl-1-propanesulfonic acid copolymers, alkali metal salts or amine salt thereof, and the like. Two or more water-soluble resins can also be used in mixture depending on the purpose.

In the case of forming the overcoat layer on the image-recording layer by partially crosslinking at least one water-soluble resin, the water-soluble resin is crosslinked by causing a crosslinking reaction using a reactive functional group that the water-soluble resin has. The crosslinking reaction may be covalent-bond crosslinking or ionic-bond crosslinking.

The crosslinking degrades the pressure-sensitive adhesiveness of the surface of the overcoat layer and improves the handleability of the lithographic printing plate precursor; however, in a case in which the crosslinking proceeds excessively, the overcoat layer changes to be lipophilic, and it becomes difficult to remove the overcoat layer on a printer, and thus an appropriate degree of partial crosslinking is preferred. A preferred degree of the partial crosslinking is a degree in which, in a case in which the lithographic printing plate precursor is immersed in water (25°C), the overcoat layer is not eluted and remains for 30 seconds to 10 minutes, but the elution of the overcoat layer is observed after 10 minutes or longer.

As a compound (crosslinking agent) that is used in the crosslinking reaction, a well-known polyfunctional compound having a crosslinking property is exemplified, and specific examples thereof include a polyepoxy compound, a polyamine compound, a polyisocyanate compound, a polyalkoxysilyl compound, a titanate compound, an aldehyde compound, a polyvalent metal salt compound, hydrazine, and the like.

The crosslinking agent can be used singly or two or more crosslinking agents can be used in mixture. A particularly preferred crosslinking agent is a water-soluble crosslinking agent, but a water-insoluble crosslinking agent can be used by being dispersed in water using a dispersant.

As a preferred combination of the water-soluble resin and the crosslinking agent, a carboxylic acid-containing water-soluble resin and a polyvalent metal compound, a carboxylic acid-containing water-soluble resin and a water-soluble epoxy resin, and a hydroxyl group-containing resin and dialdehyde are exemplified.

A preferred amount of the crosslinking agent added is 2% to 10% by mass of the water-soluble resin. In this range, the contamination of the image-recording layer by a lipophilic substance can be prevented without impairing the property of removing the overcoat layer on a printer.

To the overcoat layer, it is possible to add a water-soluble infrared absorber in order to improve the sensitivity. The infrared absorbing dye that is used in the image-recording layer is preferably used.

To the overcoat layer, in the case of applying an aqueous solution, it is possible to mainly add a nonionic surfactant for the purpose of ensuring the uniformity of the application. Specific examples of the nonionic surfactant include sorbitan tristearate, sorbitan monopalmitate, sorbitan trioleate, monoglyceride stearate, polyoxyethylene nonylphenyl ether, polyoxyethylene dodecyl ether, and the like. The amount of the nonionic surfactant added is preferably 0.05% to 5% by mass and more preferably 1% to 3% by mass of a solid substance in the overcoat layer.

In a case in which the water-soluble resin is not crosslinked, the thickness of the overcoat layer is preferably 0.1 to 4.0 μm and more preferably 0.1 to 1.0 μm, and, in a case in which the water-soluble resin is partially crosslinked, the thickness is preferably 0.1 to 0.5 μm and more preferably 0.1 to 0.3 μm. In this range, the contamination of the image-recording layer by a lipophilic substance can be prevented without impairing the property of removing the overcoat layer on a printer.

[Plate-making method]

A plate-making method in which the lithographic printing plate precursor of the embodiment of the invention is used will be described below. The plate making of the lithographic printing plate precursor of the embodiment of the invention includes a step of carrying out image exposure on the lithographic printing plate precursor and a step of carrying out on-machine development on the exposed lithographic printing plate precursor.

The image exposure is carried out by, for example, scanning exposure, infrared lamp exposure, or the like using an infrared laser, but exposure using a solid high-output infrared layer such as a semiconductor laser or a YAG laser which radiates an infrared ray having a wavelength of 700 to 1,200 nm is preferred.

The lithographic printing plate precursor of the embodiment of the invention is preferably exposed using a laser, a pulse laser, a solid-state laser, or a semiconductor laser. Regarding the amount of exposure in this case, the surface exposure intensity before modulation in an image for printing is preferably 10 to 250 $mJ/cm^2$, more preferably 30 to 200 $mJ/cm^2$, and particularly preferably 50 to 150 $mJ/cm^2$.

The image-exposed lithographic printing plate precursor is attached to an impression cylinder of a printer without

any additional treatment and then on-machine developed by an ordinary printing start operation that supplies dampening water and printing ink, and subsequently, it is possible to carry out printing on the lithographic printing plate precursor.

In a case in which an exposure device is mounted in the printer, the image-exposed lithographic printing plate precursor is attached onto a plate cylinder of the printer, then, exposed using the exposure device in the printer, and subsequently, on-machine developed, and it is possible to carry out printing on the lithographic printing plate precursor.

In the present invention, a plate-making method in which the lithographic printing plate precursor is image-exposed using an infrared laser and then a non-exposed portion of the image-recording layer is removed using at least one of printing ink and dampening water on the printer is preferred.

Examples

Hereinafter, the present invention will be described in detail using examples, but the present invention is not limited thereto. Meanwhile, for polymer compounds, unless particularly otherwise described, the molecular weight refers to the mass average molecular weight (Mw), and the ratio of a repeating unit refers to the molar percentage.

[Examples 8 to 10, Reference Examples 1 to 7 and Comparative Examples 1 to 7]

[Production of lithographic printing plate precursor]

(Production of support)

In order to remove rolling oil on the surface of a 0.3 mm-thick aluminum plate (material JIS A 1050), a defatting process was carried out thereon using an aqueous solution of 10% by mass of sodium aluminate at 50°C for 30 seconds, and then, the aluminum surface was grained using three implanted nylon brushes having hair diameters of 0.3 mm and a suspension of pumice having a median diameter of 25 μm and water (specific gravity: 1.1 g/cm$^3$) and well washed with water. The aluminum plate was etched by being immersed in an aqueous solution of 25% by mass of sodium hydroxide at 45°C for nine seconds, was washed with water, then, was further immersed in an aqueous solution of 20% by mass of nitric acid at 60°C for 20 seconds, and was washed with water. The etched amount of the grained surface at this time was approximately 3 g/m$^2$.

Next, an electrochemical roughening process was continuously carried out thereon using alternating-current voltage of 60 Hz. An electrolytic solution at this time was an aqueous solution of 1% by mass of nitric acid (including 0.5% by mass of aluminum ions), and the liquid temperature was 50°C. The electrochemical roughening process was carried out thereon using an alternating current source waveform in which the time TP taken for the current value to reach the peak from zero was 0.8 msec, a duty ratio of 1:1, a trapezoidal square-wave alternating current, and a carbon electrode as an opposite electrode. As an auxiliary anode, ferrite was used. The current density was 30 A/dm$^2$ in terms of the peak value of the current, and 5% of the current coming from the power supply was divided into the auxiliary positive electrode. Regarding the quantity of electricity during nitric acid electrolysis, the quantity of electricity was 175 C/dm$^2$ in a case in which the aluminum plate served as the positive electrode. After that, the plate was washed with water by means of spraying.

Subsequently, an electrochemical roughening process was carried out thereon using the same method as nitric acid electrolysis in an aqueous solution of 0.5% by mass of hydrochloric acid (including 0.5% by mass of aluminum ions) and an electrolytic solution having a liquid temperature of 50°C under a condition of the quantity of electricity of 50 C/dm$^2$ in a case in which the aluminum plate served as the positive electrode, and then, the plate was washed with water by means of spraying.

Next, 2.5 g/m$^2$ of a direct current anode oxide film was provided on the aluminum plate at a current density of 15 A/dm$^2$ using an aqueous solution of 15% by mass of sulfuric acid (including 0.5% by mass of aluminum ions) as an electrolytic solution, then, washed with water, and dried.

Furthermore, a silicate process was carried out on the support A using an aqueous solution of 2.5% by mass of No. 3 sodium silicate at 60°C for ten seconds, and then the support was washed with water, thereby obtaining an aluminum support. The attached amount of Si was 10 mg/m$^2$. The center line average roughness (Ra) of the aluminum support was measured using a needle having a diameter of 2 μm and was found to be 0.51 μm.

(Production of lithographic printing plate precursor)

A water-based coating fluid for an image-recording layer containing components such as a thermoplastic polymer particle, an infrared absorber, and a color developing precursor shown in Table 1 was prepared, then, applied onto the support, and dried at 50°C for one minute, thereby forming an image-recording layer and producing a lithographic printing plate precursor 1 to 12. The amounts of the respective components applied after drying are shown in Table 1.

[Table 1]

| Lithographic printing plate precursor | Infrared absorber | | Color developing precursor | | Color developing aid/acid-generating agent | | Thermoplastic polymer particle |
|---|---|---|---|---|---|---|---|
| | Kind | Amount applied | Kind | Amount applied | Kind | Amount applied | Amount applied |
| 1 | IR-1 | 0.03 $g/m^2$ | - | - | Iodonium salt A | 0.18 $g/m^2$ | 0.8 $g/m^2$ |
| 2 | IR-1 | 0.03 $g/m^2$ | - | - | Iodonium salt A TPB | 0.18 $g/m^2$ 0.01 $g/m^2$ | 0.8 $g/m^2$ |
| 3 | IR-2 | 0.03 $g/m^2$ | - | - | - | - | 1.0 $g/m^2$ |
| 4 | IR-2 | 0.03 $g/m^2$ | - | - | Iodonium salt A TPB | 0.02 $g/m^2$ 0.01 $g/m^2$ | 1.0 $g/m^2$ |
| 5 | IR-2 | 0.03 $g/m^2$ | - | - | Iodonium salt A TPB | 0.18 $g/m^2$ 0.01 $g/m^2$ | 0.8 $g/m^2$ |
| 6 | IR-3 | 0.1 $g/m^2$ | - | - | - | - | 1.0 $g/m^2$ |
| 7 | IR-3 | 0.06 $g/m^2$ | - | - | - | - | 1.0 $g/m^2$ |
| 8 | IR-4 | 0.03 $g/m^2$ | C-1 | 0.04 $g/m^2$ | - | - | 1.0 $g/m^2$ |
| 9 | IR-4 | 0.03 $g/m^2$ | C-2 | 0.04 $g/m^2$ | - | - | 1.0 $g/m^2$ |
| 10 | IR-1 | 0.02 $g/m^2$ | C-2 | 0.1 $g/m^2$ | Iodonium salt A | 0.17$g/m^2$ | 0.7 $g/m^2$ |
| 11 | IR-1 | 0.02 $g/m^2$ | C-3 | 0.1 $g/m^2$ | Iodonium salt A | 017$g/m^2$ | 0.7 $g/m^2$ |
| 12 | IR-1 | 0.02 $g/m^2$ | C-4 | 0.1 $g/m^2$ | Iodonium salt A | 017$g/m^2$ | 0.7 $g/m^2$ |

The components used for the coating fluid for an image-recording layer are as described below.

IR-1

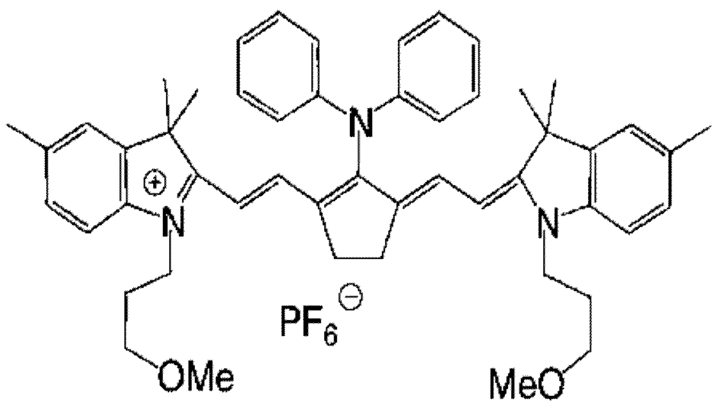

IR-2

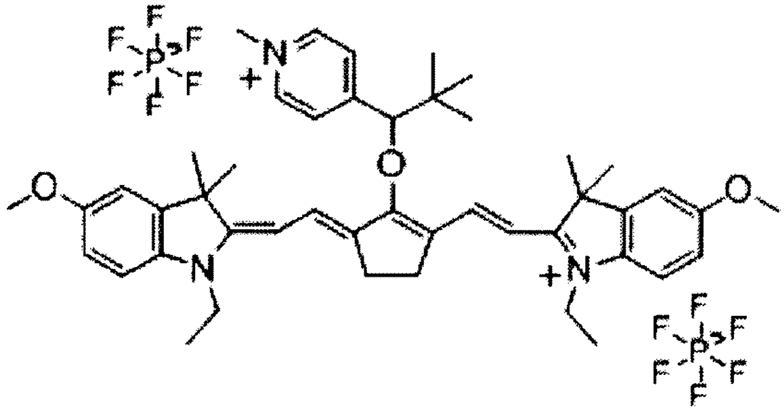

IR-3

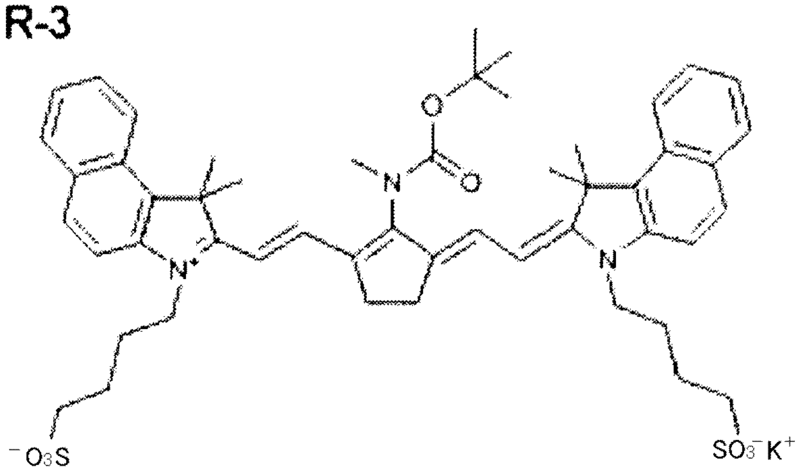

[0215]

IR-4

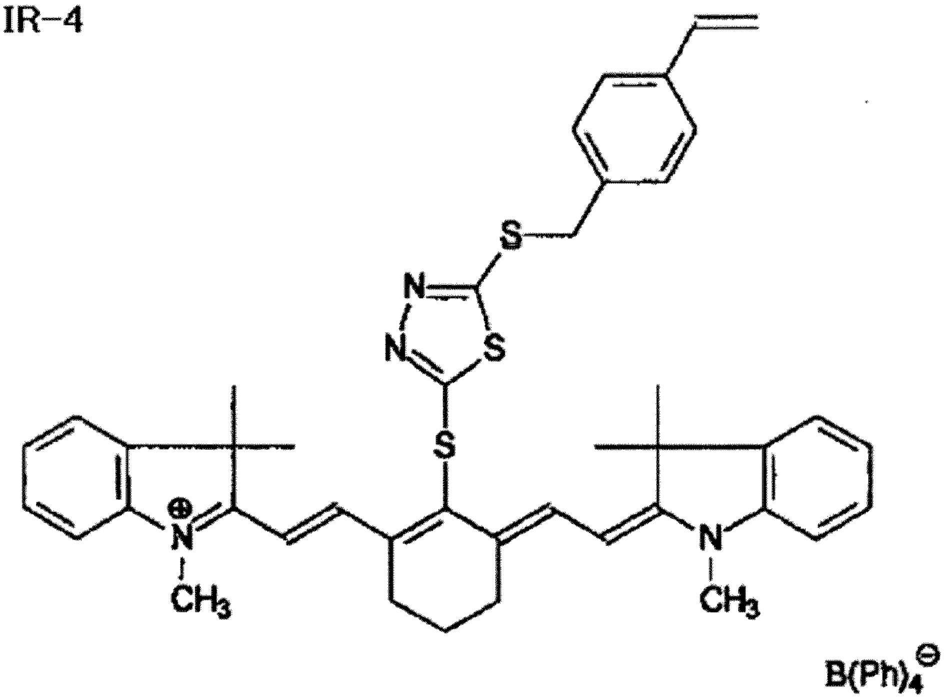

Iodonium salt A

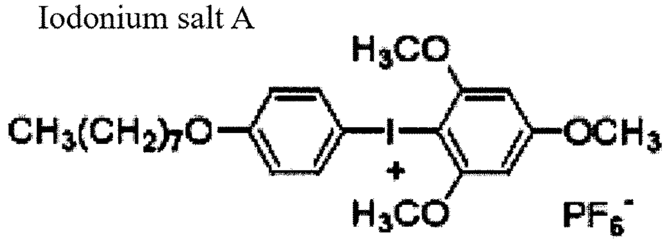

C-1: BLUE-63 manufactured by Yamamoto Chemicals Inc.
C-2: BLACK-XV manufactured by Yamamoto Chemicals Inc.
C-3: 2'-(Dibenzylamino)-6'-(diethylamino)fluorane manufactured by Tokyo Chemical Industry Co., Ltd.
C-4: Leucomalachite green manufactured by Tokyo Chemical Industry Co., Ltd.
TPB: Sodium tetraphenyl borate

Thermoplastic polymer particle: Styrene/acrylonitrile copolymer (molar ratio: 50/50), Tg: 99°C, average particle diameter: 60 nm

[Evaluation of lithographic printing plate precursor]

For the respective lithographic printing plate precursors, the visibility, the contamination of the dampening water, and the ablation were evaluated as described below. The results are shown in Table 2.

(Visibility)

The lithographic printing plate precursor was exposed to light in a Trendsetter 3244VX equipped with a water cooling-type 40 W infrared semiconductor laser manufactured by Creo Co., Ltd. at an exposure amount (plate surface energy amount) shown in Table 2 under a condition of a resolution of 2,400 dpi. As exposed images, a 2 cmx2cm solid image, a 0.2 pt register mark image that was used for visually determining the visibility, and a 7 pt letter-included image were used.

In order to evaluate the change value of the hue (Δa/Δb), the hues of the non-exposed portion and the exposed portion were measured in a specular component exclude (SCE) mode using a spectrophotometer CM2600d and operation software CM-S100W100W manufactured by Konica Minolta, Inc. Conversion was carried out according to numerical expressions described below on the basis of the L*a*b* values obtained by the measurement, and ΔL, Δa, and Δb were respectively computed.

$$\Delta L = \text{non-exposed portion } L^* \text{ value} - \text{exposed portion } L^* \text{ value}$$

$$\Delta a = |(\text{non-exposed portion } a^* \text{ value}) - (\text{exposed portion } a^* \text{ value})|$$

$$\Delta b = |(\text{non-exposed portion } b^* \text{ value}) - (\text{exposed portion } b^* \text{ value})|$$

Here, Δa and Δb are absolute values.

Meanwhile, in the visual determination, points were given by five-level evaluation.

Five points ··· favorable, four points ··· slightly favorable, three points ··· sufficient, two points ··· slightly deficient, one point ··· deficient

In order to visually determine the image, it is necessary to carry out visual determination at three or more points.

(Dampening water contamination)

The lithographic printing plate precursor (745 mm×645 mm) was attached to the cylinder of a kikuban-sized printer SX-74 manufactured by Heidelberger Druckmaschinen AG without carrying out exposure and a development process. To this printer, a 100 L-capacity dampening water circulation tank including a non-woven filter and a temperature controller was connected. PRESSMAX S-S2 (manufactured by Fujifilm Corporation) (80 L) was prepared as dampening

water in the circulation device, T&K UV OFS K-HS black GE-M (manufactured by T&K TOKA Corporation) was used as printing ink, the dampening water and the printing ink were supplied thereto, and then 500 sheets were printed at a print rate of 10,000 sheets per hour. On the 500$^{th}$ sheet, the on-machine development of the non-exposed portion of the image-recording layer was completed, and a state in which the ink was not transferred to paper for printing was formed. This test from on-machine development through the printing of 1,000 sheets was repeated 10 times, and a new lithographic printing plate precursor was used every test.

After the end of 10 times of the above-described test, the dampening water in the dampening water circulation device was collected, and the hue thereof was visually observed and evaluated on the basis of the following indexes.

<Dampening water contamination evaluation>

5: The dampening water was as colorless and transparent as the dampening water before the test and was on a favorable level.
4: Slight coloration was observed, but the dampening water was still on a favorable level.
3: The dampening water was colored, but the coloration degree was below the permissible lower limit.
2: The dampening water was colored to a high extent and was on an NG level.
1: The dampening water was significantly colored and was on a poor level.

(Ablation)

The full surfaces of fifty lithographic printing plate precursors (width: 600 nm, height: 800 nm) were exposed in a Trendsetter 3244VX manufactured by Creo Co., Ltd. The exposure amount was as shown in Table 2. A filter was attached to a pipe that connected the outlet of the exposure device and a dust collector in advance, and the contamination of the filter was observed before and after exposure and evaluated on the basis of the following indexes.

4 ··· No observed contamination, 3 ··· at the low limit of the permissible level, 2 ··· slightly contaminated, 1 ··· significantly contaminated

[Table 2]

| | Lithographic printing precursor | Exposure amount plate (mJ/cm$^2$) | Visibility | | | Dampening water contamination | Ablation |
|---|---|---|---|---|---|---|---|
| | | | ΔL | Δa/Δb | Visual determination | | |
| Example 1* | 1 | 110 | 3 | 1.4 | 4 points | 4 | 4 |
| Example 2* | 2 | 150 | 3 | 3.1 | 4 points | 4 | 4 |
| Example 3* | 3 | 80 | 3 | 3.9 | 4 points | 4 | 4 |
| Example 4* | 3 | 200 | 6 | 4.0 | 5 points | 4 | 3 |
| Example 5* | 4 | 110 | 6 | 0.6 | 4 points | 4 | 4 |
| Example 6* | 4 | 75 | 3 | 0.6 | 3 points | 4 | 4 |
| Example 7* | 5 | 150 | 6 | 1.0 | 5 points | 4 | 4 |
| Example 8 | 10 | 110 | 4 | 2.4 | 4 points | 3 | 4 |
| Example 9 | 11 | 110 | 4 | 3.9 | 4 points | 3 | 4 |
| Example 10 | 12 | 110 | 3 | 2.4 | 4 points | 3 | 4 |
| Comparative example 1 | 6 | 70 | 3 | 0.2 | 1 point | 1 | 3 |
| Comparative example 2 | 6 | 105 | 6 | 0.2 | 2 points | 1 | 2 |
| Comparative example 3 | 6 | 140 | 9 | 0.2 | 4 points | 1 | 1 |

(continued)

| | Lithographic printing precursor | Exposure amount plate (mJ/cm$^2$) | Visibility | | | Dampening water contamination | Ablation |
|---|---|---|---|---|---|---|---|
| | | | ΔL | Δa/Δb | Visual determination | | |
| Comparative example 4 | 7 | 160 | 3 | 0.2 | 1 point | 2 | 2 |
| Comparative example 5 | 7 | 250 | 6 | 0.2 | 2 points | 2 | 1 |
| Comparative example 6 | 8 | 150 | 4 | 0.1 | 2 points | 3 | 3 |
| Comparative example 7 | 9 | 150 | 4 | 0.3 | 2 points | 3 | 3 |
| *: Reference Example | | | | | | | |

From the evaluation results shown in Table 2, it is found that, in the thermal fusion-type lithographic printing plate precursors obtained in Examples 8 to 10 and Reference Examples 1 to 7, the exposed image exhibits an excellent visibility, ablation by laser exposure is suppressed, and the contamination of dampening water during on-machine development is suppressed. That is, the thermal fusion-type lithographic printing plate precursors obtained in Examples 8 to 10 and Reference Examples 1 to 7 exhibit favorable results regarding all of the visibility of the exposed image, the suppression of ablation, and the suppression of dampening water contamination. On the other hand, in the lithographic printing plate precursors of the comparative examples, the results were poor regarding all of the visibility of the exposed image, the suppression of ablation, and the suppression of dampening water contamination. For example, in a case in which the amount of the infrared absorber applied was great and the exposure amount during the image exposure was increased as in Comparative Example 3. the visibility of the exposed image was excellent, but the ablation and the dampening water contamination were poor.

According to the present invention, a thermal fusion-type lithographic printing plate precursor in which the visibility is excellent, ablation during laser exposure is suppressed, and the contamination of dampening water or printing ink during on-machine development is suppressed is obtained. In addition, a plate-making method using the lithographic printing plate precursor is obtained.

## Claims

**1.** A lithographic printing plate precursor comprising:

a support; and
an image-recording layer,
wherein the image-recording layer is capable of forming an image by infrared laser exposure, a non-exposed portion of the image-recording layer is removable by at least one of dampening water and printing ink on a printer, and the image-recording layer contains (1) a color developing system and (2) 70% by mass or more of a thermoplastic polymer particle with respect to a solid content of the image-recording layer, **characterized in that**
the color developing system has a characteristic that a hue change generated by infrared laser exposure is $\Delta a/\Delta b \geq 0.6$, and the color developing system is formed of an infrared absorbing dye and a color developing precursor, wherein the infrared absorbing dye is a cyanine colorant represented by the following General Formula (a),

General Formula (a)

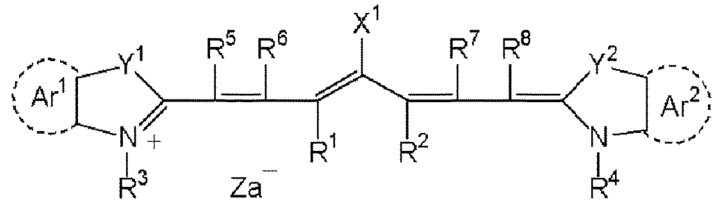

wherein, in the General Formula (a),
$X^1$ represents a hydrogen atom, a halogen atom, $-N(R^9)(R^{10})$, $X^2-L^1$, or a group described below, in which

$R^9$ and $R^{10}$ may be identical to or different from each other and represent an aromatic hydrocarbon group having 6 to 10 carbon atoms, an alkyl group having 1 to 8 carbon atoms, or a hydrogen atom, or $R^9$ and $R^{10}$ may be bonded to each other to form a ring,
$X^2$ represents an oxygen atom, a nitrogen atom, or a sulfur atom, and
$L^1$ represents a hydrocarbon group having 1 to 12 carbon atoms or a hydrocarbon group including a hetero atom and having 1 to 12 carbon atoms, in the group described below,
$X_a^-$ is same as $Z_a^-$ described below, and
$R^a$ represents a hydrogen atom or a substituent selected from an alkyl group, an aryl group, a substituted or unsubstituted amino group, and a halogen atom,

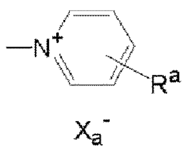

$R^1$ and $R^2$ each independently represent a hydrocarbon group having 1 to 12 carbon atoms, $R^1$ and $R^2$ may be bonded to each other to form a five-membered ring or a six-membered ring,
$Ar^1$ and $Ar^2$ may be identical to or different from each other and represent an aromatic hydrocarbon group,
$Y^1$ and $Y^2$ may be identical to or different from each other and represent a sulfur atom or a dialkyl methylene group having 12 or less carbon atoms,
$R^3$ and $R^4$ may be identical to or different from each other and represent a hydrocarbon group having 20 or less carbon atoms,
$R^5$, $R^6$, $R^7$ and $R^8$ may be identical to or different from one another and represent a hydrogen atom or a hydrocarbon group having 12 or less carbon atoms, and
$Z_a^-$ represents a counter anion, provided that, in case the cyanine colorant represented by the General Formula (a) has an anionic substituent in the structure and neutralization of a charge is not necessary, $Z_a^-$ is not required.

**2.** The lithographic printing plate precursor according to claim 1,
wherein the color developing precursor is an acid color developer.

**3.** The lithographic printing plate precursor according to claim 1 or 2,
wherein the color developing precursor is a thermal color developer.

**4.** The lithographic printing plate precursor according to claim 2,
wherein the image-recording layer further contains an acid-generating agent.

**5.** The lithographic printing plate precursor according to claim 4,
wherein the acid-generating agent is an iodonium salt, a sulfonium salt, or an azinium salt.

**6.** A plate-making method, comprising:

carrying out image exposure on the lithographic printing plate precursor according to any one of claims 1 to 5 using an infrared laser; and
removing a non-exposed portion of the image-recording layer by at least one of dampening water and printing ink on a printer.

**7.** The plate-making method according to claim 6, wherein the image exposure by the infrared laser is carried out at a surface exposure intensity of 50 to 150 $mJ/cm^2$.

## Patentansprüche

**1.** Lithographiedruckplattenvorläufer, umfassend:

einen Träger; und
eine Bildaufzeichnungsschicht,
worin die Bildaufzeichnungsschicht in der Lage ist, durch Infrarotlaserbelichtung ein Bild zu erzeugen, ein nichtbelichteter Bereich der Bildaufzeichnungsschicht durch zumindest eines von Anfeuchtwasser und Drucktinte auf einem Drucker entfernt werden kann, und die Bildaufzeichnungsschicht (1) ein Farbentwicklungssystem und (2) 70 Masse-% oder mehr eines thermoplastischen Polymerpartikels, bezogen auf den Feststoffgehalt der Bildaufzeichnungsschicht, umfasst, **dadurch gekennzeichnet, dass**
das Farbentwicklungssystem die Eigenschaften besitzt, dass die durch Infrarotlaserbelichtung generierte Farbtonveränderung $\Delta a/\Delta b \geq 0{,}6$ beträgt und das Farbentwicklungssystem aus einem infrarotabsorbierenden Farbstoff und einem Farbentwicklungsvorläufer gebildet wird, worin der infratorabsorbierende Farbstoff ein durch die folgende allgemeine Formel (a) dargestelltes Cyanin-Färbemittel ist

Allgemeine Formel (a)

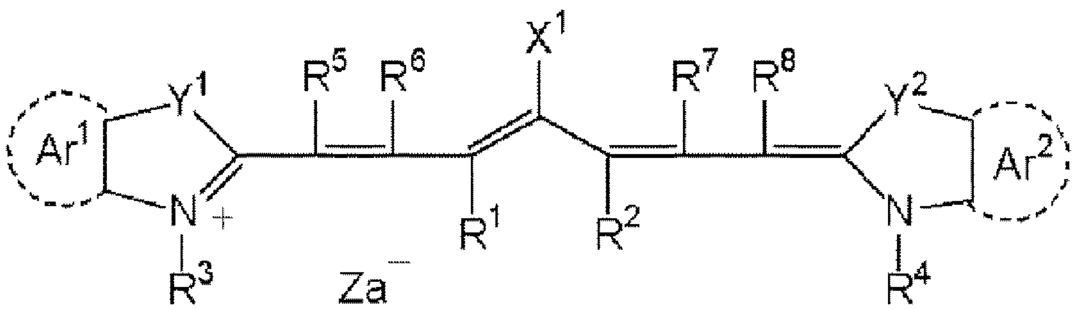

worin in der allgemeinen Formel (a)
$X^1$ ein Wasserstoffatom, ein Halogenatom, $-N(R^9)(R^{10})$, $X^2$-$L^1$ oder eine nachstehend beschriebene Gruppe darstellt, worin
$R^9$ und $R^{10}$ gleich oder voneinander verschieden sein können und eine aromatische Kohlenwasserstoffgruppe mit 6 bis 10 Kohlenstoffatomen, eine Alkylgruppe mit 1 bis 8 Kohlenstoffatomen oder ein Wasserstoffatom darstellen, oder $R^9$ und $R^{10}$ aneinander binden können, um einen Ring zu bilden,
$X^2$ ein Sauerstoffatom, ein Stickstoffatom oder ein Schwefelatom darstellt, und
$L^1$ eine Kohlenwasserstoffgruppe mit 1 bis 12 Kohlenstoffatomen oder eine Kohlenwasserstoffgruppe, die ein Heteroatom umfasst und 1 bis 12 Kohlenstoffatome aufweist, darstellt,
in der nachstehend beschriebenen Gruppe $X_a^-$ das gleiche ist wie das nachstehend beschriebene $Z_a^-$ und $R^a$ ein Wasserstoffatom oder einen Substituenten darstellt, ausgewählt aus einer Alkylgruppe, einer Arylgruppe, einer substituierten oder unsubstituierten Aminogruppe und einem Halogenatom,

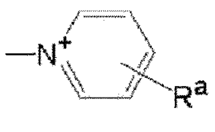

$X_a^-$

$R^1$ und $R^2$ jeweils unabhängig eine Kohlenwasserstoffgruppe mit 1 bis 12 Kohlenstoffatomen darstellen, wobei $R^1$ und $R^2$ aneinander binden können, um einen fünfgliedrigen oder einen sechsgliedrigen Ring zu bilden,
$Ar^1$ und $Ar^2$ gleich oder voneinander verschieden sein können und eine aromatische Kohlenwasserstoffgruppe darstellen,

$Y^1$ und $Y^2$ gleich oder voneinander verschieden sein können und ein Schwefelatom oder eine Dialkylmethylengruppe mit 12 oder weniger Kohlenstoffatomen darstellen,
$R^3$ und $R^4$ gleich oder voneinander verschieden sein können und eine Kohlenwasserstoffgruppe mit 20 oder weniger Kohlenstoffatomen darstellen,
$R^5$,$R^6$, $R^7$ und $R^8$ gleich oder voneinander verschieden sein können und ein Wasserstoffatom oder eine Kohlenwasserstoffgruppe mit 12 oder weniger Kohlenstoffatomen darstellen und
$Z_a^-$ ein Gegenanion darstellt, mit der Maßgabe, dass, wenn das durch die allgemeine Formel (a) dargestellte Cyanin-Färbemittel einen anionischen Substituenten in der Struktur aufweist und die Neutralisation einer Ladung nicht notwendig ist, $Z_a^-$ nicht erforderlich ist.

**2.** Lithographiedruckplattenvorläufer gemäß Anspruch 1, worin der Farbentwicklungsvorläufer ein Säure-Farbentwickler ist.

**3.** Lithographiedruckplattenvorläufer gemäß Anspruch 1 oder 2, worin der Farbentwicklungsvorläufer ein thermischer Farbentwickler ist.

**4.** Lithographiedruckplattenvorläufer gemäß Anspruch 2, worin die Bildaufzeichnungsschicht ferner einen Säurebildner umfasst.

**5.** Lithographiedruckplattenvorläufer gemäß Anspruch 4, worin der Säurebildner ein Iodoniuimsalz, ein Sulfoniumsalz oder ein Aziniumsalz ist.

**6.** Plattenherstellungsverfahren, umfassend:

Durchführen einer Bildbelichtung an dem Lithographiedruckplattenvorläufer gemäß irgendeinem der Ansprüche 1 bis 5 unter Verwendung eines Infrarotlasers; und
Entfernen eines nicht-belichteten Bereichs der Bildaufzeichnungsschicht durch zumindest eines von Anfeuchtwasser und Drucktinte auf einem Drucker.

**7.** Plattenherstellungsverfahren gemäß Anspruch 6, worin die Bildbelichtung mit dem Infrarotlaser bei einer Oberflächenbelichtungsintensität von 50 bis 150 mJ/$cm^2$ durchgeführt wird.

## Revendications

**1.** Précurseur de plaque d'impression lithographique comprenant :

un support ; et
une couche d'enregistrement d'image,
dans lequel la couche d'enregistrement d'image est apte à former une image par exposition au laser infrarouge, une portion non exposée de la couche d'enregistrement d'image peut être retirée par au moins l'une parmi de l'eau de mouillage et de l'encre d'impression sur une imprimante, et la couche d'enregistrement d'image contient (1) un système de développement de couleurs et (2) 70 % en masse ou plus d'une particule de polymère thermoplastique par rapport à une teneur en solides de la couche d'enregistrement d'image, **caractérisé en ce que**
le système de développement de couleurs présente une caractéristique selon laquelle un changement de tonalité généré par exposition au laser infrarouge est $\Delta a/\Delta b \geq 0,6$, et le système de développement de couleurs est composé d'un colorant absorbant l'infrarouge et d'un précurseur de développement de couleurs, dans lequel le colorant absorbant l'infrarouge est un colorant cyanine représenté par la formule générale (a) suivante,

Formule générale (a)

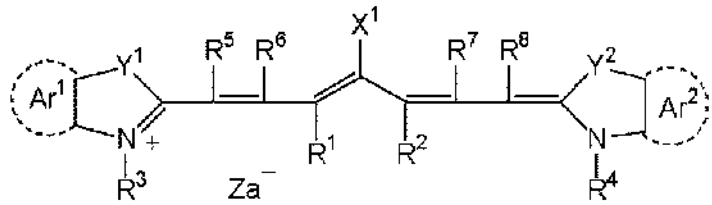

dans lequel, dans la formule générale (a),

$X^1$ représente un atome d'hydrogène, un atome d'halogène, -N($R^9$)($R^{10}$), $X^2$-$L^1$, ou un groupe décrit ci-dessous, dans lequel

$R^9$ et $R^{10}$ peuvent être identiques ou différents l'un de l'autre et représentent un groupe hydrocarboné aromatique présentant 6 à 10 atomes de carbone, un groupe alkyle présentant 1 à 8 atomes de carbone, ou un atome d'hydrogène, ou $R^9$ et $R^{10}$ peuvent être liés l'un à l'autre pour former un cycle,
$X^2$ représente un atome d'oxygène, un atome d'azote, ou un atome de soufre, et
$L^1$ représente un groupe hydrocarboné présentant 1 à 12 atomes de carbone ou un groupe hydrocarboné incluant un hétéroatome et présentant 1 à 12 atomes de carbone, dans le groupe décrit ci-dessous,
$X_a^-$ est identique à $Z_a^-$ décrit ci-dessous, et
$R^a$ représente un atome d'hydrogène ou un substituant sélectionné parmi un groupe alkyle, un groupe aryle, un groupe amino substitué ou non substitué, et un atome d'halogène,

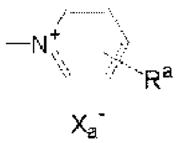

$R^1$ et $R^2$ représentent chacun indépendamment un groupe hydrocarboné présentant 1 à 12 atomes de carbone, $R^1$ et $R^2$ peuvent être liés l'un à l'autre pour former un cycle à cinq chaînons ou un cycle à six chaînons,
$Ar^1$ et $Ar^2$ peuvent être identiques ou différents l'un de l'autre et représentent un groupe hydrocarboné aromatique,
$Y^1$ et $Y^2$ peuvent être identiques ou différents l'un de l'autre et représentent un atome de soufre ou un groupe méthylène de dialkyle présentant 12 atomes de carbone ou moins,
$R^3$ et $R^4$ peuvent être identiques ou différents l'un de l'autre et représentent un groupe hydrocarboné présentant 20 atomes de carbone ou moins,
$R^5$, $R^6$, $R^7$ et $R^8$ peuvent être identiques ou différents les uns des autres et représentent un atome d'hydrogène ou un groupe hydrocarboné présentant 12 atomes de carbone ou moins, et
$Z_a^-$ représente un contre-anion, à condition que, dans le cas où le colorant cyanine représenté par la formule générale (a) présente un substituant anionique dans la structure et que la neutralisation d'une charge n'est pas nécessaire, $Z_a^-$ ne soit pas requis.

2. Précurseur de plaque d'impression lithographique selon la revendication 1, dans lequel le précurseur de développement de couleurs est un révélateur chromogène acide.

3. Précurseur de plaque d'impression lithographique selon la revendication 1 ou 2, dans lequel le précurseur de développement de couleurs est un révélateur chromogène thermique.

4. Précurseur de plaque d'impression lithographique selon la revendication 2, dans lequel la couche d'enregistrement d'image contient en outre un agent générateur d'acide.

5. Précurseur de plaque d'impression lithographique selon la revendication 4, dans lequel l'agent générateur d'acide est un sel d'iodonium, un sel de sulfonium, ou un sel d'azinium.

**6.** Procédé de fabrication d'une plaque, comprenant :

la mise en œuvre d'une exposition selon une image sur le précurseur de plaque d'impression lithographique selon l'une quelconque des revendications 1 à 5 en utilisant un laser infrarouge ; et

le retrait d'une portion non exposée de la couche d'enregistrement d'image par au moins l'une parmi de l'eau de mouillage et de l'encre d'impression sur une imprimante.

**7.** Procédé de fabrication d'une plaque selon la revendication 6, dans lequel l'exposition selon une image par le laser infrarouge est mise en œuvre à une intensité d'exposition de surface de 50 à 150 $mJ/cm^2$.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2016027886 A
- JP 2008544322 A
- EP 1428676 A2
- EP 2072570 A1
- WO 2006005688 A1
- JP 2008195018 A
- JP 2001133969 A
- JP 2002023360 A
- JP 2002040638 A
- JP 2001277730 A
- US 4708925 A
- JP 7020629 A
- JP H07020629 A
- US 5135838 A
- US 5200544 A
- JP 2100054 A
- JP H02100054 A
- JP 2100055 A
- JP H02100055 A
- JP 9197671 A
- JP H09197671 A
- JP 2008001740 A
- JP 61166544 A
- JP S61166544 A
- JP 2003328465 A
- JP 2000066385 A
- JP 2000080068 A
- JP 7271029 A
- JP H07271029 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 A
- WO 9634316 A
- JP 54031187 A
- JP S54031187 A
- JP 54063902 A
- JP S54063902 A
- GB 1412768 A
- US 3511661 A
- JP 2001253181 A
- JP 2001322365 A
- JP 10282679 A
- JP H10282679 A
- JP 2304441 A
- JP H02304441 A
- JP 2005125749 A
- JP 2006188038 A


### Non-patent literature cited in the description


- *J. C. S. Perkin II,* 1979, 1653-1660
- *J. C. S. Perkin II,* 1979, 156-162
- *Journal of Photopolymer Science and Technology,* 1995, 202-232
- *Research Disclosure,* January 1992